# EUROPEAN PATENT SPECIFICATION

(11) **EP 4 167 403 B1**
(45) Date of publication and mention of the grant of the patent: **14.02.2024**
(21) Application number: 22200174.5
(22) Date of filing: 07.10.2022
(51) Int. Cl.: H01S 5/11, H01S 5/185, H01S 5/34

(54) **SURFACE EMITTING QUANTUM CASCADE LASER**
OBERFLÄCHENEMITTIERENDER QUANTENKASKADENLASER
LASER À CASCADE QUANTIQUE À ÉMISSION DE SURFACE

(30) Priority: 14.10.2021 JP 2021169039
(43) Date of publication of application: 19.04.2023
(73) Proprietor: National Institute for Materials Science, Tsukuba-shi, Ibaraki 305-0047 (JP); Kabushiki Kaisha Toshiba, Tokyo 105-8001 (JP)
(72) Inventor: SAKODA, Kazuaki, Ibaraki, 3050047 (JP); YAO, Yuanzhao, Ibaraki, 3050047 (JP); KURODA, Takashi, Ibaraki, 3050047 (JP); IKEDA, Naoki, Ibaraki, 3050047 (JP); SUGIMOTO, Yoshimasa, Ibaraki, 3050047 (JP); MANO, Takaaki, Ibaraki, 3050047 (JP); SAITO, Shinji, Tokyo, 1058001 (JP); HASHIMOTO, Rei, Tokyo, 1058001 (JP); KANEKO, Kei, Tokyo, 1058001 (JP); KAKUNO, Tsutomu, Tokyo, 1058001 (JP); OHNO, Hiroshi, Tokyo, 1058001 (JP)
(74) Representative: J A Kemp LLP

(56) References cited:
- US-A1- 2014 348 195
- US-A1- 2021 249 841
- US-B2- 7 656 925
- US-B2- 9 130 339

## Description

### TECHNICAL FIELD

The present invention relates to a surface emitting quantum cascade laser. Specifically, the present invention relates to a surface emitting quantum cascade laser having a photonic crystal with a structure capable of improving the radiation loss ratio in a resonance mode. Also, the present invention relates to a surface emitting quantum cascade laser having a photonic crystal with a structure capable of reducing the absorption of laser light in the laser element.

### BACKGROUND ART

A quantum cascade laser is a relatively new semiconductor laser of which the oscillation was confirmed in 1994 for the first time, and is the only one compact laser source that can cover a wavelength band from mid-infrared to far-infrared including a wavelength of 3 to 5 µm and even to the extent of a terahertz region. Since absorption peaks of a variety of gas species exist in a wavelength band of 3 to 5 µm, the concentration of various gases can be measured by using a quantum cascade laser.

Also, a quantum cascade laser has been extremely attracting much attention because it can measure an isotope ratio by utilizing single-wavelength properties of a laser and there is no other simple alternative measurement method.

Also, a quantum cascade laser can measure a minute amount at a level of ppb because it can improve the sensitivity by a multi-pass mirror system in which gas is passed between facing mirrors to perform analysis by utilizing straightness of a laser. By further application of this straightness, it has been expected to create a new technique capable of detecting a dangerous gas in a remote location such as a gas that comes from a volcano.

However, in the case of applying a quantum cascade laser to the improvement of sensitivity by the above-described multi-pass mirror system, the detection of a dangerous gas in a remote location, or the like, a high-quality beam capable of maintaining the beam shape even with a long optical path length is required. In addition, in the case of applying a quantum cascade laser to the detection of a dangerous gas in a remote location, high output is also required because laser light needs to be propagated to cover a long distance.

Thus, in order to realize these characteristics, as the quantum cascade laser, a high-output and high-quality surface emitting quantum cascade laser that incorporates a photonic crystal structure at a position close to an active layer (that is, light-emitting layer) of the laser element has been studied and developed (Patent Literatures 1 and 2).

For example, Patent Literature 1 discloses that by a surface emitting quantum cascade laser having a so-called composite structure constituted of two types of two-dimensional lattices (that is, two types of photonic crystals), suppression of leakage of laser light from the side surface of its laser can be achieved.

Further, Patent Literature 2 discloses that by a surface emitting semiconductor laser element characterized by having a diffraction grating of square lattice (that is, photonic crystal), and having a triangular prism shape with a bottom face of an approximate right triangle shape as the unit structure, improvement of the laser beam quality can be achieved.

US 2021/249841 A1 discloses a surface emitting quantum cascade laser having a rectangular-lattice photonic crystal with a pentagonal unit lattice.

### CITATION LIST

### PATENT LITERATURE

PATENT LITERATURE 1: JP 2019-47023 A
PATENT LITERATURE 2: JP 2014-197659 A
PATENT LITERATURE 3: US 2021/249841 A1

### SUMMARY OF INVENTION

### TECHNICAL PROBLEM

The above photonic crystal for use in a surface emitting quantum cascade laser is a structure body in which a plurality of materials having different refractive indexes are periodically two-dimensionally arrayed, and is incorporated so as to come close to an active layer of the laser element by means of a nano-processing technique such as an electron beam lithography. In this case, by properly designing a resonance mode of light of the photonic crystal and matching the resonance frequency with a gain frequency band of the laser, the laser oscillation is achieved, and further the surface emission of laser light in the direction perpendicular to the emission surface is realized. Since the emission surface can have a large area of not less than 100 µm square and can suppress the spread of a laser beam due to diffraction, it is possible to realize the excellent beam quality in principle when a surface emitting quantum cascade laser is used. Further, since it is possible to make the area of an active region of a laser larger, it can be expected that a larger laser output can be obtained by the surface emitting quantum cascade laser.

However, in general, it is necessary to energize a laser element in order to supply power to a quantum cascade laser, and thus, in such a quantum cascade laser, it is necessary to add (that is, dope) impurities (that is, dopants) to semiconductor layers constituting the laser element to increase the electric conductivity of the semiconductor layers. By the way, increasing the electric conductivity of semiconductor layers in a surface emitting quantum cascade laser causes absorption of laser light and decreases a radiation loss ratio in an optical resonance mode of a photonic crystal, and as a result, it becomes a factor that lowers the extraction efficiency of the laser light. Herein, the term "radiation loss ratio" means a ratio of a laser output to the total loss including absorption loss.

As described above, since the light absorption in the laser element is unavoidable in principle in a surface emitting quantum cascade laser, there is a problem that the extraction efficiency of laser light is low in such a surface emitting quantum cascade laser. This causes a reduction in the efficiency of conversion from electricity to light and a decrease in the laser output, and further causes a number of problems that are directly linked to deterioration of characteristics of a surface emitting quantum cascade laser, for example, an increase in the element temperature due to the influence of the laser power absorbed inside the laser element, and the like are caused.

For such reasons, it is important to improve the extraction efficiency of laser light in a surface emitting quantum cascade laser, but the extraction efficiency of laser light is not yet sufficient in the conventional surface emitting quantum cascade laser as described above. In addition, in a surface emitting quantum cascade laser, it is also important to be able to realize the excellent beam quality as the surface emitting quantum cascade laser. Accordingly, it is desired to develop a novel surface emitting quantum cascade laser that is different from the conventional surface emitting quantum cascade laser.

In order to solve the problem described above, an object of the present invention is to provide a novel surface emitting quantum cascade laser that is different from the conventional surface emitting quantum cascade laser and can realize the excellent beam quality as the surface emitting quantum cascade laser.

Also, an object of the present invention is to provide a surface emitting quantum cascade laser having a photonic crystal with a structure capable of improving the radiation loss ratio in a resonance mode. And, an object of the present invention is to increase the extraction efficiency of laser light by the improvement of the radiation loss ratio.

Also, an object of the present invention is to provide a surface emitting quantum cascade laser having a photonic crystal with a structure capable of reducing the absorption of laser light in the laser element. And, an object of the present invention is to increase the extraction efficiency of laser light by the reduction in the absorption of laser light.

Also, an object of the present invention is to provide a surface emitting quantum cascade laser that can realize the excellent beam quality as the surface emitting quantum cascade laser even if the amount of impurities doped in semiconductor layers constituting the laser element is reduced.

### SOLUTION TO PROBLEM

As a result of intensive studies, the present inventors have found that the problem described above can be solved by a surface emitting quantum cascade laser as defined in claim 1 of the appended set of claims.

In addition, the present inventors have found that the problem described above can also be solved by a surface emitting quantum cascade laser as defined in claim 12 of the appended set of claims.

Further, the present inventors have found that the problem described above can also be solved by a surface emitting quantum cascade laser as defined in claim 13 of the appended set of claims.

The present inventors have completed the present invention based on these findings.

Specifically, the present invention is set out in the appended set of claims.

### ADVANTAGEOUS EFFECTS OF INVENTION

According to the present invention, a novel surface emitting quantum cascade laser that is different from the conventional surface emitting quantum cascade laser and can realize the excellent beam quality as the surface emitting quantum cascade laser can be provided.

Also, according to the present invention, a surface emitting quantum cascade laser having a photonic crystal with a structure capable of improving the radiation loss ratio in a resonance mode can be provided. And, the extraction efficiency of laser light can be increased by the improvement of the radiation loss ratio.

Also, according to the present invention, a surface emitting quantum cascade laser having a photonic crystal with a structure capable of reducing the absorption of laser light in the laser element can be provided. And, the extraction efficiency of laser light can be increased by the reduction in the absorption of the laser light.

Also, according to the present invention, a surface emitting quantum cascade laser that can realize the excellent beam quality as the surface emitting quantum cascade laser even if the amount of impurities doped in semiconductor layers constituting the laser element is reduced can be provided. For example, a surface emitting quantum cascade laser that can realize the excellent beam quality even if a doping density of a laser active layer is not more than 1×10¹⁸ cm⁻³ and a doping density of semiconductor layers excluding the active layer is not more than 1×10¹⁹ cm⁻³ can be provided.

As described above, according to the present invention, a surface emitting quantum cascade laser having a photonic crystal with a structure capable of improving the radiation loss ratio can be provided. Here, by designing the structure of the photonic crystal so as to have an effective radiation loss ratio (specifically, large radiation loss ratio), a large extraction efficiency of laser light can be realized. For example, an extraction efficiency exceeding 40% as the extraction efficiency of laser light can be realized. Further, according to the present invention, even in the case where the unit lattice of the photonic crystal is a square lattice, an extraction efficiency of laser light (specifically, approximately not less than 15%) which is higher than that of a conventional surface emitting semiconductor laser element using, as the unit lattice, the same square-lattice photonic crystal can be realized. According to the present invention, since a large extraction efficiency of laser light can be realized, improvement of the laser output, improvement of the efficiency of conversion from electricity to light, and suppression of the temperature rise of the laser element can be expected. By the suppression of the temperature rise, simplification of an element cooling mechanism can also be expected.

According to the present invention, a photonic crystal with a structure capable of improving the radiation loss ratio is used, and thus in the light band structure of the photonic crystal, the Q factor in a resonance mode at the Γ point which is an important index of a surface emitting laser can be precisely designed. As a result, realization of the large extraction efficiency of laser light can be expected. The photonic crystal with a structure capable of improving the radiation loss ratio which is used in the present invention can be one bringing characteristics significantly excellent in quality as compared with a conventionally used square-lattice photonic crystal or triangular-lattice photonic crystal.

### BRIEF DESCRIPTION OF DRAWINGS

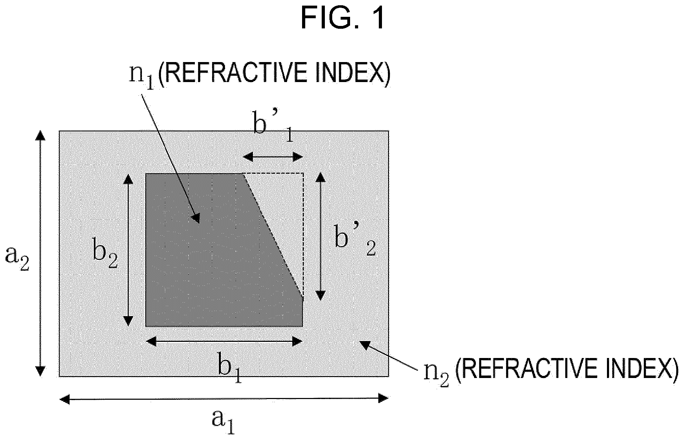

FIG. 1 is a plan view of one embodiment of a unit lattice of a photonic crystal constituting the surface emitting quantum cascade laser of the present invention, as viewed from the emission direction of laser light (herein, the unit lattice in the figure is a square or rectangular lattice with lengths of "a₁" and "a₂", is constituted of a compound semiconductor composition or metal composition having a refractive index of "n₂", and includes a compound semiconductor composition having a pentagonal shape and a refractive index of "n₁" in the central part. And, the pentagonal shape is a shape lacking a right triangle shape having a length of "b₁'" as a base and a length of "b₂'" as a height from one corner of a square or rectangle having a side length of "b₁" in the lateral direction and a side length of "b₂" in the longitudinal direction.);

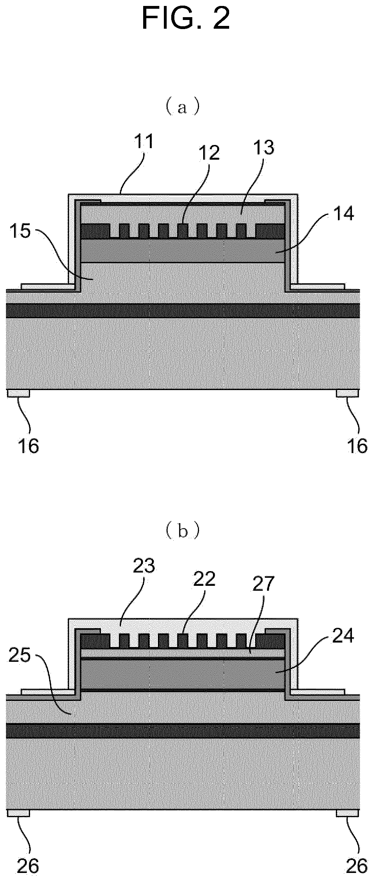

FIGS. 2(a) and 2(b) are figures (specifically, side views) each showing one embodiment of a structure of a surface emitting quantum cascade laser manufactured in "Example 1-1" (herein, FIG. 2(a) shows an embodiment in which InP is used for embedding grooves of a photonic crystal, and FIG. 2(b) shows an embodiment in which a Ti thin film and gold are used for embedding grooves of a photonic crystal);

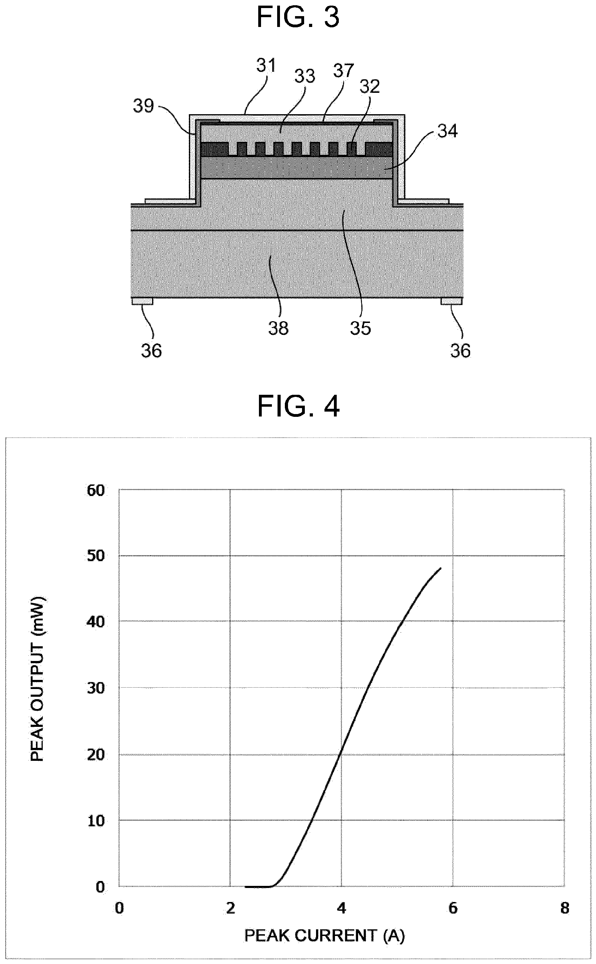

FIG. 3 is a figure (specifically, side view) showing one embodiment of a structure of a surface emitting quantum cascade laser manufactured in Example 1-2;
FIG. 4 is a figure showing output characteristics of laser oscillation by a surface emitting quantum cascade laser manufactured in Example 1-2;

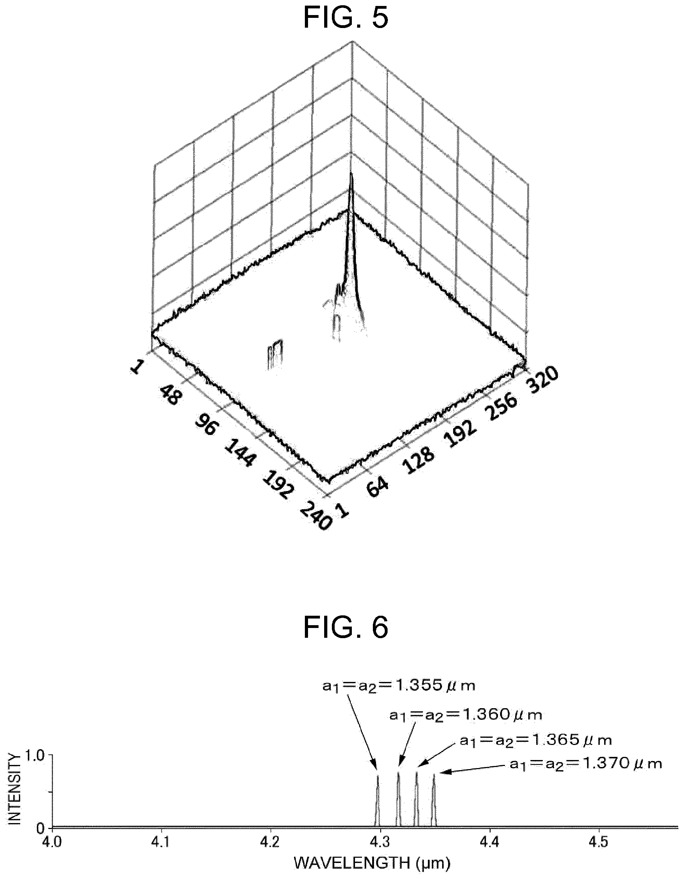

FIG. 5 is a figure showing far-field profiles of a laser beam by a surface emitting quantum cascade laser manufactured in Example 1-2;
FIG. 6 is a figure showing the laser oscillation spectra of three types of surface emitting quantum cascade lasers newly manufactured according to the method of Example 1-2 together with the laser oscillation spectrum of a surface emitting quantum cascade laser manufactured in Example 1-2 (herein, the spectra in the figure show, in order from the top, each spectrum of the three cases where a photonic crystal constituting surface emitting quantum cascade laser and having a unit lattice of a square lattice satisfies, as lengths of "a₁" and "a₂" shown in FIG. 1, each condition of "a₁ = a₂ = 1.355 µm, 1.360 µm, 1.365 µm, and 1.370 µm", in order from the top.);

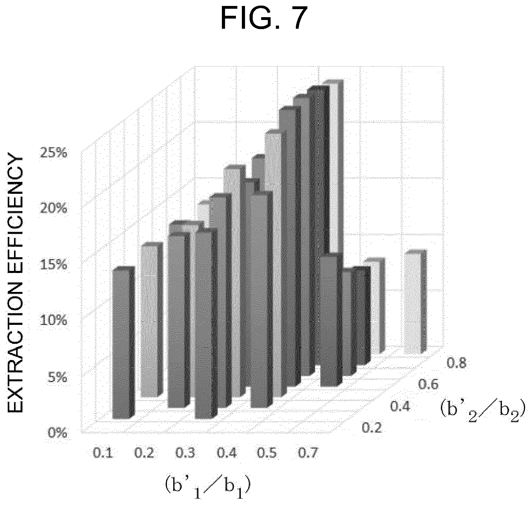

FIG. 7 is a figure showing the results of numerically calculating, by a finite element method, the influence on the extraction efficiency (%) of laser light caused by changing the size (specifically, (b_{1'} /b₁) and (b₂'/b₂)) of a pentagonal shape in the central part of a unit lattice structure in a photonic crystal constituting a surface emitting quantum cascade laser manufactured according to the method of Example 1-2, wherein the unit lattice is a square lattice with one side length of 1.355 µm which means the lengths of "a₁" and "a₂" shown in FIG. 1 are the same;

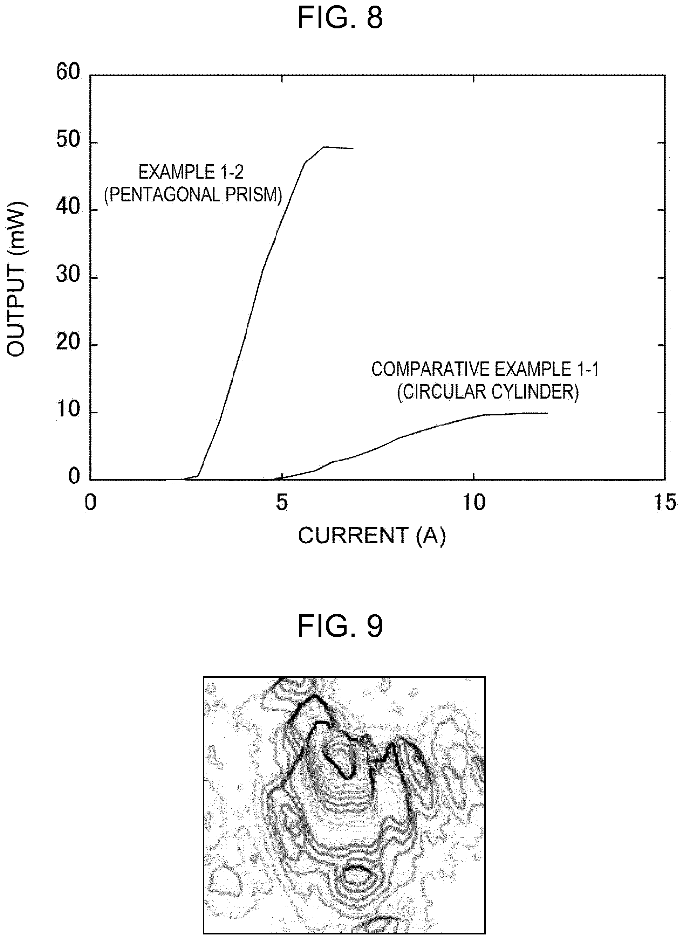

FIG. 8 is a figure showing the comparison results between the output characteristics (that is, laser oscillation characteristics) of a surface emitting quantum cascade laser of "Comparative Example 1-1" and a surface emitting quantum cascade laser of "Example 1-2" (in the figure, the surface emitting quantum cascade laser of "Comparative Example 1-1" is different from the surface emitting quantum cascade laser of "Example 1-2" in that the part of the pentagonal shape in a unit lattice of a photonic crystal shown in FIG. 1 of "Comparative Example 1-1" is a circular structure);
FIG. 9 is a figure showing far-field profiles of a laser beam of "Comparative Example 1-1";

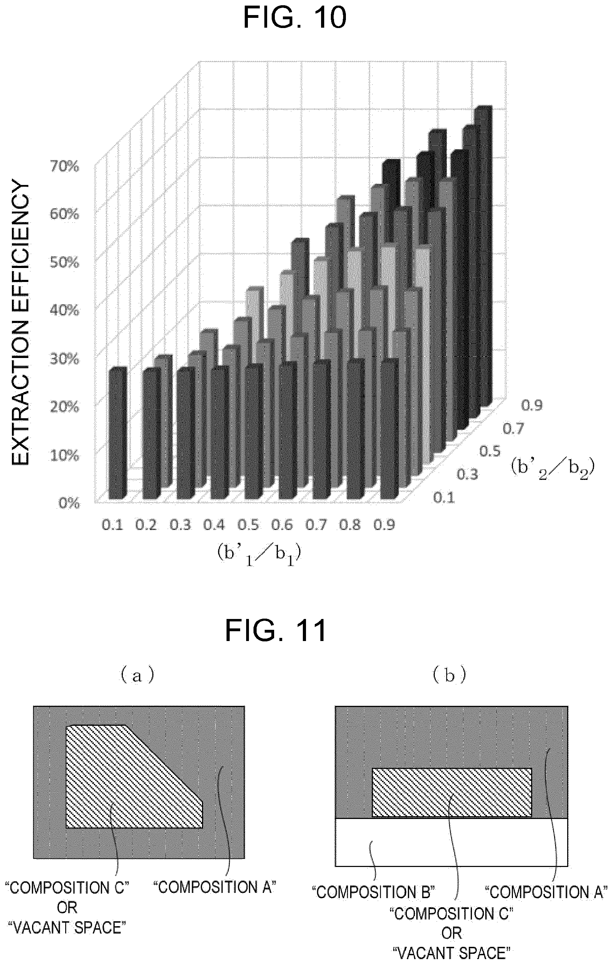

FIG. 10 is a figure showing the results of numerically calculating, by a finite element method, the influence on the extraction efficiency (%) of laser light caused by changing the size (specifically, (b_{1'} /b₁) and (b₂'/b₂)) of a pentagonal shape in the central part of a unit lattice structure in a photonic crystal constituting a surface emitting quantum cascade laser manufactured according to the method of Example 1-2, wherein the unit lattice is a rectangular lattice (a₁ = 1.380 µm, and a₂ = 1.656 µm) which means the lengths of "a₁" and "a₂" shown in FIG. 1 are different from each other; and
FIGS. 11(a) and11(b) are figures showing another embodiment, which is different from that of FIG. 1, of a unit lattice of a photonic crystal constituting the surface emitting quantum cascade laser of the present invention (herein, FIG. 11(a) is a plan view as viewed from the emission direction of laser light, and FIG. 11(b) shows a side view).

### DESCRIPTION OF EMBODIMENTS

Hereinafter, the embodiments for carrying out the present invention will be described in detail. In this regard, the present invention should not be limited to the following embodiments, and it should be noted that various modifications can be made within the scope of the gist.

One aspect of the present invention relates to a surface emitting quantum cascade laser having semiconductor layers other than a laser active layer and the laser active layer, and further having a square-lattice or rectangular-lattice photonic crystal on the above laser active layer. Further, a unit lattice of the square-lattice or rectangular-lattice photonic crystal is made of a composition A, and a composition B having a refractive index different from a refractive index of the composition A, wherein the composition A is a compound semiconductor composition or metal composition and the composition B is a compound semiconductor composition. Furthermore, the unit lattice of the square-lattice or rectangular-lattice photonic crystal has a structure in which a columnar structure body having a pentagonal bottom face and being made of the composition B is provided in the central part of a columnar structure body having a square or rectangular bottom face and being made of the composition A.

In the present invention, the laser active layer is a so-called light-emitting layer, and is specifically a layer being constituted of a so-called "multi-quantum well (MQW)" in which a plurality of quantum well layers are stacked and emitting laser light due to the intersubband transition. The laser active layer may be simply referred to as an "active layer", and may be simply referred to as an "active layer" also in the present application.

In the present invention, the expression "semiconductor layers other than a laser active layer" means all the semiconductor layers (for example, cladding layer, and photonic crystal) other than the laser active layer constituting the above surface emitting quantum cascade laser according to one aspect of the present invention.

It is preferable that each quantum well layer constituting the laser active layer is a layer which contains any one of a group III-V compound semiconductor composition, a compound semiconductor composition made of ZnO and ZnMgO, or a compound semiconductor composition made of Si and SiGe. Herein, the term "contains" means that dopants (that is, impurities) may be doped (that is, added) as needed. From the viewpoint of reducing a doping amount in semiconductor layers constituting the laser element, it is desirable to reduce the doping amount as much as possible. Specifically, it is preferable to be doped in an amount so that a doping density of the whole laser active layer is not more than 1×10¹⁸ cm⁻³.

The above group III-V compound semiconductor composition is preferably at least one selected from the group consisting of a compound semiconductor composition made of InGaAs and AlInAs (the composition may be referred to as "InGaAs/AlInAs"), a compound semiconductor composition made of GaAs and InGaAs (the composition may be referred to as "GaAs/InGaAs"), a compound semiconductor composition made of GaAs and AlGaAs (the composition may be referred to as "GaAs/AlGaAs"), a compound semiconductor composition made of InAs and AlGaSb (the composition may be referred to as "InAs/AlGaSb"), a compound semiconductor composition made of GaN and AlGaN (the composition may be referred to as "GaN/AlGaN"), and a compound semiconductor composition made of GaN and InGaN (the composition may be referred to as "GaN/InGaN"). In this case, as the substrate, an InP substrate is preferable in the case where the group III-V compound semiconductor composition is "InGaAs/AlInAs", a GaAs substrate is preferable in the case where the group III-V compound semiconductor composition is "GaAs/InGaAs" or "GaAs/AlGaAs", an InAs substrate is preferable in the case where the group III-V compound semiconductor composition is "InAs/AlGaSb", and a GaN substrate is preferable in the case where the group III-V compound semiconductor composition is "GaN/AlGaN" or "GaN/InGaN".

The substrate in the case of using a compound semiconductor composition made of ZnO and ZnMgO (the composition may be referred to as "ZnO/ZnMgO") is preferably a ZnO substrate.

The substrate in the case of using a compound semiconductor composition made of Si and SiGe (the composition may be referred to as "Si/SiGe") is preferably a Si substrate.

A photonic crystal is an artificial crystal having a nano-periodic structure in which substances having different refractive indexes are arranged at intervals almost the same as the wavelength of light. Since a phenomenon that light is trapped inside or cannot enter occurs, the photonic crystal is used to trap light in a small region and to enhance the interaction between the light and substances.

The unit lattice of the square-lattice or rectangular-lattice photonic crystal used in the present invention is made of a compound semiconductor composition or metal composition (the composition is also, in the present application, referred to as "composition A" for convenience), and a compound semiconductor composition having a refractive index different from a refractive index of the composition A (the compound semiconductor composition is also, in the present application, referred to as "composition B" for convenience).

Both the composition A and the composition B preferably contain a group III-V compound semiconductor composition as the compound semiconductor composition. Typical examples of the group III-V compound semiconductor composition include InP, InGaAs, GaAs, AlGaAs, GaInP, InAs, AlInAs, and GaP, and it is preferable to use at least one selected from the group consisting of these compound semiconductor compositions. Herein, the above term "contain" means that dopants (that is, impurities) may be doped (that is, added) as needed. From the viewpoint of reducing a doping amount in semiconductor layers constituting the laser element, it is desirable to reduce the doping amount as much as possible. Specifically, it is preferable to be doped in an amount so that a doping density of the whole semiconductor layers other than the laser active layer is not more than 1 ×10¹⁹ cm⁻³.

In the case where both the composition A and the composition B use the group III-V compound semiconductor composition, it is necessary to select the group III-V compound semiconductor composition having refractive indexes different from each other. Although depending on the structure of a photonic crystal, it is generally preferable to select one having a high refractive index and one having a low refractive index, and it is more preferable to select ones of which the difference between the refractive indexes becomes higher.

As for the combination of the composition A and the composition B, it is preferable to use, for example, an InP compound semiconductor composition or a metal composition as the composition A, and an InGaAs compound semiconductor composition as the composition B.

In the case where a metal composition is used as the composition A, the metal composition means to be a composition containing a metal. As the typical example, for example, a composition containing gold, copper, nickel, titanium, or any combination thereof can be included, and such a metal may be used alone or may be used as the main component. In the case where a metal composition is used as the composition A, it is preferable to use a metal composition containing gold as the main component (for example, metal composition made of gold and Ti, wherein the gold is contained as the main component). In this regard, a metal composition used as the composition A may be simply referred to as "metal" in the present application.

The unit lattice of a photonic crystal is a square or rectangular lattice. From the viewpoint of increasing the radiation loss ratio, a rectangular lattice is preferable.

In the surface emitting quantum cascade laser according to one aspect of the present invention, a unit lattice of a square-lattice or rectangular-lattice photonic crystal has a structure in which a columnar structure body having a pentagonal bottom face and being made of a composition B is provided in the central part of a columnar structure body having a square or rectangular bottom face and being made of a composition A. That is, the square-lattice or rectangular-lattice photonic crystal has a structure in which a columnar structure body having a pentagonal bottom face and being made of a composition B (that is, pentagonal prism structure body) is provided in the central part of a columnar structure body having a square or rectangular bottom face and being made of a composition A, as a base unit, and is arrayed two-dimensional periodically.

The outline of the structure of a unit lattice of a square-lattice or rectangular-lattice photonic crystal is shown in FIG. 1 as a plan view as viewed from the emission direction of laser light when a surface emitting quantum cascade laser is manufactured using the photonic crystal.

As shown in FIG. 1, when viewed two-dimensionally, the structure of the unit lattice of the square-lattice or rectangular-lattice photonic crystal has a square or rectangle shape part made of a composition A and a pentagonal shape part made of a composition B in the central part of the square or rectangle shape part.

In the manufacture of the unit lattice of a square-lattice or rectangular-lattice photonic crystal, at first, a pentagonal shape part is manufactured by the manufacture of a thin film by means of the molecular beam epitaxy (MBE) method and the metal organic vapor phase growth method, and by means of a nano-processing method using an electron beam lithography, with the use of a composition B (for example, InGaAs having a refractive index "n₁" of 3.40 in the drawing). The manufactured pentagonal shape part is made of a composition B, and corresponds to a photonic crystal. Next, by embedding a gap between the pentagonal shape parts being made of a composition B and being arrayed two-dimensional periodically, with a composition A (for example, InP having a refractive index "n₂" of 3.07) without leaving any space, a square or rectangle shape part made of the composition A is manufactured. As a result, as shown in FIG. 1, the unit lattice of the above photonic crystal has a structure of: having a square or rectangle shape part made of a composition A; and having a pentagonal shape part made of a composition B in the central part of the square or rectangle shape part.

As shown in FIG. 1, in the case where the side length in the lateral direction is "a₁" and the side length in the longitudinal direction is "a₂" of a square or rectangle shape part made of a composition A (that is, the shape part means unit lattice of a square-lattice or rectangular-lattice photonic crystal), the value of (a₂/a₁) indicating the ratio of the side length (a₂) in the longitudinal direction to the side length (a₁) in the lateral direction is in the range of not less than 1 and not more than 2, preferably in the range of not less than 1 and not more than 1.8, and more preferably in the range of not less than 1 and not more than 1.5. The side length "a₁" in the lateral direction and the side length "a₂" in the longitudinal direction have only to be adjusted on the basis of the calculation results by a finite element method depending upon the target laser oscillation wavelength. However, usually, in the case where the average refractive index of the photonic crystal is "n" and the laser oscillation wavelength is "λ (unit: nm)", the side length "a₁" in the lateral direction is preferably a value satisfying "na₁/λ = not less than 0.8 and not more than 1.2", and more preferably a value satisfying "na₁/λ = not less than 0.9 and not more than 1.1". In this case, the side length "a₂" in the longitudinal direction is preferably a value satisfying "na₂/λ = not less than 0.8 and not more than 2.4", and more preferably a value satisfying "na₁/λ = not less than 0.9 and not more than 2.0".

As shown in FIG. 1, the pentagonal shape part made of a composition B (that is, photonic crystal part) is a shape part lacking (that is, removing) a right triangle shape part from one corner of a square or rectangle shape part having the side length of "b₁" in the lateral direction and the side length of "b₂" in the longitudinal direction. The value of (b₂/b₁) indicating the ratio of the side length (b₂) in the longitudinal direction to the side length (b₁) in the lateral direction is in the range of not less than 1 and not more than 2, preferably in the range of not less than 1 and not more than 1.8, and more preferably in the range of not less than 1 and not more than 1.5. In this regard, the side length (b₁) in the lateral direction is preferably determined so that the ratio of the composition B to the unit lattice is in the range of not less than 20% and not more than 80%. Accordingly, the value of (b₁/a₁) indicating the ratio to the side length (a₁) in the lateral direction is preferably in the range of not less than 0.2 and not more than 0.8, more preferably in the range of not less than 0.3 and not more than 0.7, and even more preferably in the range of not less than 0.4 and not more than 0.6.

As shown in FIG. 1, the value of (b₁'/b₁) indicating the ratio of the base side length (b₁') to the side length (b₁) in the lateral direction is, in the case where the above photonic crystal is a rectangular lattice, in the range of not less than 0.1 and not more than 0.9, preferably in the range of not less than 0.2 and not more than 0.9, and more preferably in the range of not less than 0.3 and not more than 0.9. Further, the value of (b₂'/b₂) indicating the ratio of the height (b₂') to the side length (b₂) in the longitudinal direction is, in the case where the above photonic crystal is a rectangular lattice, in the range of not less than 0.3 and not more than 0.9, preferably in the range of not less than 0.5 and not more than 0.9, and more preferably in the range of not less than 0.6 and not more than 0.9. In the case where the above photonic crystal is a square lattice, the value of (b₁'/b₁) is in the range of not less than 0.1 and not more than 0.5, and preferably in the range of not less than 0.2 and not more than 0.5. Further, in the case where the photonic crystal is a square lattice, the value of (b₂'/b₂) is in the range of not less than 0.3 and not more than 0.9, and preferably in the range of not less than 0.5 and not more than 0.9.

In the surface emitting quantum cascade laser according to one aspect of the present invention, the ratio of a columnar structure body having a pentagonal bottom face and being made of a composition B to a unit lattice of a square-lattice or rectangular-lattice photonic crystal is preferably in the range of not less than 20% and not more than 80%, more preferably in the range of not less than 30% and not more than 70%, and even more preferably in the range of not less than 40% and not more than 60%.

In the surface emitting quantum cascade laser according to one aspect of the present invention, dopants (that is, impurities) may be doped (that is, added) as a laser active layer, but from the viewpoint of reducing a doping amount in semiconductor layers constituting the laser element, it is desirable to reduce the doping amount as much as possible. Specifically, it is preferable that a doping density of the laser active layer is not more than 1 ×10¹⁸ cm⁻³, and a doping density of semiconductor layers other than the laser active layer is not more than 1×10¹⁹ cm⁻³. A doping density of the laser active layer is more preferably not more than 1×10¹⁷, and even more preferably not more than 5×10¹⁶. Further, a doping density of semiconductor layers other than the laser active layer is more preferably not more than 1×10¹⁸, and even more preferably not more than 5×10¹⁷.

In the surface emitting quantum cascade laser according to one aspect of the present invention, from the viewpoint of the utilization for analysis of various gas species, the excellent beam quality, and the like, a laser oscillation wavelength is preferably not less than 3 µm and not more than 9 µm, and more preferably not less than 4 µm and not more than 8 µm.

Hereinafter, as for the present invention, another aspect will be described, which is different from the surface emitting quantum cascade laser according to one aspect of the present invention. In this case, the above explanation which has been already mentioned on the above surface emitting quantum cascade laser according to one aspect of the present invention will be applied similarly, unless otherwise indicated.

Another aspect of the present invention relates to a surface emitting quantum cascade laser having semiconductor layers other than a laser active layer and the laser active layer, and further having a square-lattice or rectangular-lattice photonic crystal on the laser active layer, wherein a unit lattice of the square-lattice or rectangular-lattice photonic crystal is made of a composition A, a composition B having a refractive index different from a refractive index of the composition A, and a composition C having a refractive index different from both refractive indexes of the compositions A and B, the composition A is a compound semiconductor composition or metal composition, the composition B is a compound semiconductor composition, and the composition C is a dielectric composition. Further, the unit lattice of the square-lattice or rectangular-lattice photonic crystal has the following structure: a columnar structure body having a square or rectangular bottom face and being made of the composition A is provided on a layer made of the composition B; a columnar structure body having a pentagonal bottom face made of the composition C is provided in the central part of the columnar structure body having the square or rectangular bottom face and being made of the composition A, and the pentagonal bottom face of the columnar structure body having the pentagonal bottom face and being made of the composition C is positioned on the layer made of the composition B; and the columnar structure body having the pentagonal bottom face and being made of the composition C is embedded in the columnar structure body having the square or rectangular bottom face and being made of the composition A.

The unit lattice of a photonic crystal used in the surface emitting quantum cascade laser according to another aspect of the present invention is made of a compound semiconductor composition or metal composition (the composition is also, in the present invention, referred to as "composition A" for convenience), a compound semiconductor composition having a refractive index different from a refractive index of the composition A (the composition is also, in the present invention, referred to as "composition B" for convenience), and a dielectric composition having a refractive index different from both refractive indexes of the compositions A and B (the composition is also, in the present invention, referred to as "composition C" for convenience).

As the composition C, it is preferable to use SiO₂ as a dielectric composition. Typical examples of the dielectric composition include Si₃N₄, ZrO, and TiO₂, and it is preferable to use at least one selected from the group consisting of these dielectric compositions.

The outline of the structure of the unit lattice of a square-lattice or rectangular-lattice photonic crystal is shown in FIGS. 11(a) and 11(b) as a plan view and a side view as viewed from the emission direction of laser light when a surface emitting quantum cascade laser is manufactured using the photonic crystal.

As shown in FIG. 11(a), when viewed two-dimensionally, the structure of the unit lattice of a square-lattice or rectangular-lattice photonic crystal has a square or rectangle shape part made of a composition A, and a pentagonal shape part made of a composition C in the central part of the square or rectangle shape part. Further, as shown in FIG. 11(b), the unit lattice of the square-lattice or rectangular-lattice photonic crystal has the following structure: a columnar structure body having a square or rectangular bottom face and being made of the composition A and a columnar structure body having a pentagonal bottom face and being made of the composition C provided (that is, arranged) in the central part of the columnar structure body having the square or rectangular bottom face and being made of a composition A are positioned on a layer made of a composition B. Furthermore, the columnar structure body having the pentagonal bottom face and being made of a composition C has a structure of being embedded in the columnar structure body having the square or rectangular bottom face and being made of the composition A.

In the unit lattice of a photonic crystal used in the surface emitting quantum cascade laser according to further another aspect of the present invention, the part constituted of the composition C is made as a vacant space. The outline of the structure of the unit lattice of the square-lattice or rectangular-lattice photonic crystal in this case is a structure of replacing the part constituted of the composition C with a vacant space, as shown in FIGS. 11(a) and 11(b). For this reason, the unit lattice of the square-lattice or rectangular-lattice photonic crystal used in the above surface emitting quantum cascade laser according to another aspect of the present invention has the following structure: a columnar structure body having a square or rectangular bottom face and being made of a composition A and a spatial columnar structure body having a pentagonal bottom face provided (that is, arranged) as a vacant space in the central part of the columnar structure body having the square or rectangular bottom face and being made of the composition A are positioned on a layer made of a composition B. Further, the spatial columnar structure body having the pentagonal bottom face in the columnar structure body having the square or rectangular bottom face and being made of the composition A is present as a vacant space without penetrating through the columnar structure body having the square or rectangular bottom face and being made of the composition A. For this reason, as shown in FIG. 11(b), the spatial columnar structure body having the pentagonal bottom face has a structure of being embedded in the columnar structure body having a square or rectangular bottom face and being made of a composition A.

The conditions not specified in the present application are not particularly limited as long as the object of the present invention can be achieved.

### Examples

Hereinafter, embodiments of the present invention will be described in more detail with reference to Examples, but the embodiments of the present invention are not limited to the following Examples as long as they do not exceed the gist of the present invention.

### Example 1-1

### <Manufacture and effect of surface emitting quantum cascade laser (1)>

Two types of surface emitting quantum cascade lasers shown in FIGS. 2(a) and (b) were manufactured using the molecular beam epitaxy (MBE) method. FIGS. 2(a) and (b) are side views of the manufactured surface emitting quantum cascade lasers.

In the two types of surface emitting quantum cascade lasers shown in FIGS. 2(a) and (b), each of the active layers (which mean laser active layers) 14 and 24 of light-emitting layers is made of a multi-quantum well (MQW), in which an InGaAs thin film and an AlInAs thin film are the main constituent elements and each of the lower cladding layers 15 and 25 is made of a N-type InP substrate and an InP thin film formed on the substrate. The lower cladding layers 15 and 25 are also referred to as InP cladding layers 15 and 25. The lower cladding layers 15 and 25 were also manufactured by means of the MBE method. In the multi-quantum well (MQW), Si was doped as another constituent element, and its doping amount was set to an amount so that the doping density in the active layers 14 and 24 was not more than 1×10¹⁸ cm⁻³.

Photonic crystals 12 and 22 containing InGaAs as the main component were incorporated on upper surfaces of the active layers 14 and 24. In this regard, in FIG. 2(b), an upper cladding layer 27 of InP (the layer is also referred to as "InP cladding layer 27") was arranged on the upper surface of the active layer 24. The manufacture of the photonic crystals 12 and 22 was performed as follows: at first, the InGaAs thin film having a thickness of 1 µm was manufactured, in FIG. 2(a), on an upper surface of the active layer 14 by means of the MBE method, and was manufactured, in FIG. 2(b), on an upper surface of the InP cladding layer 27 by means of the MBE method. Next, an electron beam resist was applied on each of the InGaAs thin films, and then was processed into a two-dimensional periodic array of the pentagonal prisms with electron beam exposure by means of an electron beam lithography and with dry etching, in accordance with the design as shown in FIG. 1.

In order to efficiently diffuse the generated heat of a laser element to suppress the temperature rise of the element, in FIG. 2(a), grooves (that is, gaps between the adjacent pentagonal prisms) in a photonic crystal 12 obtained by etching were embedded with InP by growing an InP film by means of the metal organic vapor phase growth method, and further on the upper part, an InP film having a thickness of approximately 3 µm was manufactured to form a cladding layer (the layer is referred to as "embedded InP cladding layer 13"). Similarly, also in FIG. 2(b), grooves (that is, gaps between the adjacent pentagonal prisms) in a photonic crystal 22 obtained by etching were embedded with a metal made of gold and Ti (that is, Ti/Au metal), which contains the gold as the main component, and further on the upper part, a Ti/Au metal film having a thickness of approximately 1 µm was manufactured to form a Ti/Au metal layer (the layer is referred to as "embedded Ti/Au metal layer 23"). It was confirmed by observation with an electron microscope that a two-dimensional periodic array of the pentagonal prisms was formed and the grooves (that is, gaps between the adjacent pentagonal prisms) were embedded (that is, filled) without leaving any space. In the case of being embedded with InP, a metal electrode made of Ti and Au (that is, Ti/Au electrode 11) was manufactured as an electrode for current injection on the upper surface. Although not shown in a figure, a metal electrode was similarly manufactured also in FIG. 2(b). Further, an insulating film of SiO₂ was provided. Furthermore, the metal electrodes 16 and 26 (specifically, Ti/Au electrodes) for current injection were attached also on the lower surface of the InP substrate. An opening for extracting laser light was arranged in the center (not shown in a figure).

In this regard, the doping amount doped in an area other than the active layers 14 and 24 was set to an amount so that a doping density in the area except for the active layers 14 and 24 was not more than 1×10¹⁹ cm⁻³.

FIG. 1 is a plan view showing a unit lattice of photonic crystals 12 and 22 as viewed from the emission direction of laser light in a surface emitting quantum cascade laser. By using FIG. 1, structures of the photonic crystals 12 and 22 designed in the present Example will be described. In the figure, each unit lattice of the photonic crystals 12 and 22 was designed so that the length of "a₁" was 1.37 µm, the length of "a₂" was 1.644 µm, the length of "b₁" was 1.123 µm, the length of "b₂" was 1.348 µm, the length of "b₁" was 0.786 µm, and the length of "b₂'" was 0.943 µm. That is, each of the photonic crystals 12 and 22 has a unit lattice of a rectangular lattice. For this reason, the two-dimensional structure of each unit lattice of the photonic crystals 12 and 22 has a rectangular shape with a length of "a₁" in the longitudinal direction and a length of "a₂" in the lateral direction, and also has a pentagonal shape part made of a material different from the material constituting the rectangular shape part in the central part of the rectangular shape. Here, according to FIG. 2(a), the rectangle shape part corresponds to the embedded InP cladding layer 13, and according to FIG. 2(b), the rectangle shape part corresponds to the embedded Ti/Au metal layer 23. Thus, the material of the rectangle shape part in FIG. 2(a) is InP and the material of the rectangle shape part in FIG.2(b) is a Ti/Au metal. Further, since the pentagonal shape part in FIG. 2(a) corresponds to a photonic crystal 12 and the pentagonal shape part in FIG. 2(b) corresponds to a photonic crystal 22, both the materials of the pentagonal shape parts in FIGS. 2 (a) and 2(b) are InGaAs except for doped components.

In FIG. 2(a), the refractive index "n₁" of InGaAs of a material for the pentagonal shape part was 3.40, and the refractive index "n₂" of InP of a material for the rectangular shape part was 3.07.

In FIG. 2(b), the refractive index "n₁" of InGaAs of a material for the pentagonal shape part was 3.40, and the refractive index "n₂" of Ti/Au metal of a material for the rectangular shape part was 3.53.

In both FIGS. 2(a) and 2(b), since the unit lattice having the above structure was periodically manufactured in an amount of about 360 pieces × 300 pieces for the laser element, the area of the whole photonic crystal was a size of about 500 µm × 500 µm.

As for the effects of the two types of the manufactured surface emitting quantum cascade lasers shown in FIGS. 2(a) and (b), it was confirmed that the laser oscillation was able to be achieved as a surface emitting quantum cascade laser and the excellent beam quality was able to be realized by cooling the temperature to a liquid nitrogen temperature and performing laser oscillation by current injection (not shown in a figure).

### Example 1-2

### <Manufacture and effect of surface emitting quantum cascade laser (2)>

A surface emitting quantum cascade laser shown in FIG. 3 was manufactured in a similar manner to Example 1-1. FIG. 3 is a side view of the manufactured surface emitting quantum cascade laser.

Specifically, in the surface emitting quantum cascade laser of FIG. 3, an active layer 34 of a light-emitting layer is made of a multi-quantum well (MQW), in which an InGaAs thin film and an AlInAs thin film are the main constituent elements and a lower cladding layer 35 is made of a N-type InP substrate and an InP thin film formed on the substrate and is also referred to as an InP cladding layer 35. The lower cladding layer 35 was also manufactured by means of the MBE method. In the multi-quantum well (MQW), Si was doped as another constituent element, and its doping amount was set to an amount so that the doping density in the active layer 34 was not more than 1×10¹⁸ cm⁻³.

A photonic crystal 32 containing InGaAs as the main component was incorporated on an upper surface of the active layer 34. In the manufacture of a photonic crystal 32, at first, an InGaAs thin film having a thickness of 1 µm was manufactured on an upper surface of the active layer 34 by means of the MBE method, an electron beam resist was applied on the InGaAs thin film, and then the obtained thin film was processed into a two-dimensional periodic array of pentagonal prisms with electron beam exposure by means of an electron beam lithography and with dry etching, in accordance with the design shown in FIG. 1.

In order to efficiently diffuse the generated heat of a laser element to suppress the temperature rise of the element, grooves (that is, gaps between the adjacent pentagonal prisms) in a photonic crystal 32 obtained by etching were embedded with InP by growing an InP film by means of the metal organic vapor phase growth method, and further on the upper part, an InP film 37 having a thickness of approximately 3 µm was manufactured to form a cladding layer (the layer is referred to as "embedded InP cladding layer 33"). It was confirmed by observation with an electron microscope that a two-dimensional periodic array of the pentagonal prisms was formed and the grooves (that is, gaps between the adjacent pentagonal prisms) were embedded (that is, filled) without leaving any space. An InGaAs layer 37 having a thickness of approximately 0.1 µm was further formed on the embedded InP cladding layer 33. A metal electrode made of Ni and Au (that is, Ni/Au electrode 31) was manufactured as an electrode for current injection on the upper surface of the InGaAs layer 37. Further, an insulating film 39 of SiO₂ was arranged. Furthermore, a metal electrode 36 (specifically, Ni/Au electrode) for current injection was attached also on the lower surface of the InP substrate 38. An opening for extracting laser light was arranged in the center (not shown in a figure).

In this regard, the doping amount doped in an area other than the light-emitting layer (that is, active layer) 34 was set to an amount so that a doping density in the area except for the light-emitting layer 34 was not more than 1×10¹⁹ cm⁻³.

FIG. 1 is a plan view showing a unit lattice of a photonic crystal 32 as viewed from the emission direction of laser light in a surface emitting quantum cascade laser. By using FIG. 1, a structure of the photonic crystal 32 designed in the present Example will be described. In the drawing, a unit lattice of the photonic crystal 32 was designed so that both the lengths of "a₁" and "a₂" were 1.355 µm, both the lengths of "b₁" and "b₂" were 1.065 µm, the length of "b₁'" was 0.426 µm, and the length of "b₂'" was 0.852 µm. That is, the photonic crystal 32 has a unit lattice of a square lattice. For this reason, the two-dimensional structure of the unit lattice of the photonic crystal 32 has a square shape with a length of "a₁" in the longitudinal direction and a length of "a₂" in the lateral direction wherein both the lengths of "a₁" and "a₂" are the same, and also has a pentagonal shape part made of a material different from the material constituting the square shape part in the central part of the square shape. Here, since the square shape part corresponds to the embedded InP cladding layer 33, the material of the square shape part is InP. Further, since the pentagonal shape part corresponds to the photonic crystal 32, the material is InGaAs. The refractive index "n₁" of InGaAs being a material for the pentagonal shape part was 3.40, and the refractive index "n₂" of InP being a material for the square shape part was 3.07.

Since the unit lattice having the above structure was periodically manufactured in an amount of about 370 pieces × 370 pieces for the laser element, the area of the whole photonic crystal was a size of about 500 µm × 500 µm.

The effect of the manufactured surface emitting quantum cascade laser shown in FIG. 3 was confirmed by cooling the temperature to a liquid nitrogen temperature and performing laser oscillation by current injection in a similar manner to Example 1. The results of output characteristics of the surface emitting quantum cascade laser manufactured in the present Example are shown in FIG. 4. From the results, it was confirmed that the laser oscillation threshold current was about 2.8 A, and the maximum output was about 50 mW.

Further, the results of far-field profiles of an output laser beam of the surface emitting quantum cascade laser manufactured in the present Example are shown in FIG. 5. From the results, it was confirmed that a unimodal output beam with a small beam spread angle was obtained.

From these results, it was confirmed that according to the surface emitting quantum cascade laser manufactured in the present Example, the laser oscillation was able to be achieved as a surface emitting quantum cascade laser and the excellent beam quality was able to be realized.

### Comparative Example 1-1

### <Manufacture of surface emitting quantum cascade laser for comparison>

A general surface emitting quantum cascade laser having a structure in which only the shape of a bottom face of a pentagonal prism part in a unit lattice constituting a photonic crystal 32 in the surface emitting quantum cascade laser manufactured in Example 1-2 was replaced with a circular cylinder as a circular shape with a diameter of 1.102 µm was manufactured as Comparative Example 1-1. The manufacturing method is similar to that in Example 1-2 except that only the shape of a pentagonal prism part in a unit lattice was replaced with a shape of a circular cylinder.

The results of output characteristics of the surface emitting quantum cascade laser of Comparative Example 1-1 are shown in FIG. 8 together with the results of output characteristics of the surface emitting quantum cascade laser of Example 1-2.

From the results, it was confirmed that the surface emitting quantum cascade laser of Comparative Example 1-1 had a laser output smaller than that of the surface emitting quantum cascade laser of Example 1-2.

Further, the results of far-field profiles of a laser beam by the surface emitting quantum cascade laser of Comparative Example 1-1 are shown in FIG. 9. It was confirmed that the far-field profiles were different from the far-field profiles of FIG. 5 that show far-field profiles of a laser beam by the surface emitting quantum cascade laser of Example 1-2, showed a donut-like shape, and had a large beam spread angle.

From these results, it was confirmed that in the surface emitting quantum cascade laser of Comparative Example 1-1, the beam quality was low, and the excellent beam quality, realized in Example 1-2 of the surface emitting quantum cascade laser according to one embodiment of the present invention was not obtained.

### Example 2-1

### <Effect of structure of unit lattice of photonic crystal on laser oscillation wavelength>

Three types of surface emitting quantum cascade lasers, each of which is manufactured in Example 1-2 and shown in FIG. 3, were newly manufactured in a similar manner to Example 1-2. These three types of surface emitting quantum cascade lasers were manufactured, as for the structure of the unit lattice of photonic crystal 32 constituting the surface emitting quantum cascade laser, so that only one side length (specifically, both the lengths of "a₁" and "a₂" in FIG. 1 are the same 1.355 µm) of the unit lattice of the square lattice of the photonic crystal 32 in Example 1-2 was different from one another within the range of 1.355 µm to 1.370 µm. Specifically, the three types of the manufactured surface emitting quantum cascade lasers relate to the surface emitting quantum cascade laser shown in FIG. 3. And, one of them has further a structure in which both the lengths of "a₁" and "a₂" shown in FIG. 1 are the same 1.360 µm, another one has a structure in which both the lengths of "a₁" and "a₂" shown in the FIG. 1 are the same 1.365 µm, and the other one has a structure in which both the lengths of "a₁" and "a₂" shown in the FIG. 1 are the same 1.370 µm.

The effects of the three types of the manufactured surface emitting quantum cascade lasers were confirmed by cooling the temperature to a liquid nitrogen temperature and performing laser oscillation by current injection in a similar manner to Example 1-2. The results of laser oscillation spectra of the three types of the manufactured surface emitting quantum cascade lasers are shown in FIG. 6 together with the results of laser oscillation spectrum of the surface emitting quantum cascade laser of Example 1-2. From the results, it was confirmed that the laser oscillation wavelength (µm) increased with the increase in the lengths of a unit lattice of a square lattice of a photonic crystal 32. Accordingly, it was confirmed that the laser oscillation wavelength was able to be adjusted by adjusting the unit lattice structure of the photonic crystal 32. Further, from the results of FIG. 6, it was confirmed that all of the laser oscillation wavelengths (µm) were about 4.3 to 4.4 µm, and were within the range of not less than 3 µm and not more than 9 µm.

It was confirmed as described above that according to the surface emitting quantum cascade laser manufactured in the present Example, the laser oscillation was able to be achieved as a surface emitting quantum cascade laser and the excellent beam quality was able to be realized.

### Example 2-2

### <Effect of structure of unit lattice of photonic crystal on extraction efficiency of laser light (1)>

As for the case where a surface emitting quantum cascade laser shown in FIG. 3 was manufactured in a similar manner to Example 1-2, the effect of the structure of a unit lattice of the photonic crystal 32 constituting the surface emitting quantum cascade laser on the extraction efficiency of laser light was investigated. Specifically, as for the extraction efficiency of laser light of the surface emitting quantum cascade laser, the value of (b₁'/b₁) indicating the ratio of the length of "b₁'" to the length of "b₁" in FIG. 1, and the dependency on the value of (b₂'/b₂) indicating the ratio of the length of "b₂'" to the length of "b₂" were numerically calculated by a finite element method. The extraction efficiency of laser light is generally defined as a ratio of the laser output to the total energy loss caused by a surface emitting quantum cascade laser, but in the present Example, for the sake of simplification of the calculation, the energy loss due to spontaneous emission, which did not affect the extraction efficiency of laser light because of the relatively small contribution, was not considered, and the total energy loss was defined as the sum of the reabsorption of laser light inside the element and the laser output emitted outside the element. For this reason, the extraction efficiency of laser light is also an average value of the extraction efficiencies of laser light on a plurality of electromagnetic resonance modes included in a gain spectrum of an active layer. In this regard, the unit lattice of a photonic crystal 32 is the same square lattice as in Example 1-2 (that is, both the lengths of "a₁" and "a₂" in FIG. 1 are the same 1.355 µm). The results are shown in FIG. 7.

From the results, it was confirmed that as for the extraction efficiency of laser light, there were optimum values for the values of (b₁'/b₁) and (b₂'/b₂), and specifically, a large extraction efficiency of approximately not less than 15% was obtained in the case where the value of (b₁'/b₁) satisfied 0.1 ≤ (b₁'/b₁) ≤ 0.5 and the value of (b₂'/b₂) satisfied 0.3 ≤ (b₂'/b₂) ≤ 0.9.

In this regard, it was also confirmed that this tendency was also applied to the case where the surface emitting quantum cascade lasers shown in FIGS. 2(a) and (b) were manufactured in a similar manner to Example 1-1 (not shown in a figure).

### Example 2-3

### <Effect of structure of unit lattice of photonic crystal on extraction efficiency of laser light (2)>

The extraction efficiency of laser light from a surface emitting quantum cascade laser was also numerically calculated by a finite element method. In this case, in consideration of only the main factors that determine the extraction efficiency of laser light (specifically, only the diffraction efficiency of an electromagnetic mode, and the reabsorption by semiconductor layers and an upper surface electrode), the reabsorption by a back electrode and the dissipation of laser light in the horizontal direction, which did not substantially affect the extraction efficiency of laser light because of the relatively small contribution, were ignored.

As for the surface emitting quantum cascade laser manufactured in a similar manner to Example 1-2, the effect of the structure of a photonic crystal constituting the surface emitting quantum cascade laser on the extraction efficiency of laser light was investigated. Specifically, the unit lattices of the photonic crystals 12, 22, and 32, each of which constitutes the surface emitting quantum cascade laser, were rectangular lattices in each of which the length of "a₁" is 1.380 µm and the length of "a₂" is "1.2 × a₁ (= 1.656 µm)" in FIG. 1. In addition, the pentagonal shape which is a bottom face of a pentagonal prism positioned in the central part of a unit lattice of the rectangular lattice was designed so that the area of the pentagonal shape with a length of "b₂" of "1.2 × b₁" and a length of "b₁" in FIG. 1 was 50% of the area of the unit lattice.

As for the surface emitting quantum cascade laser in which the photonic crystal has such a structure, the effects of the value of (b₁'/b₁) indicating the ratio of the length of "b₁" to the length of "b₁" and the value of (b₂'/b₂) indicating the ratio of the length of "b₂" to the length of "b₂" on the extraction efficiency of laser light were investigated. In this regard, the doping density of the embedded InP cladding layers 13 and 33 and the doping density of the photonic crystals 12, 22, and 33 of InGaAs were 4×10¹⁶ cm⁻³ and 1×10¹⁷ cm⁻³, respectively, and the doping density of a multi-quantum well layer was set to 5×10¹⁶ cm⁻³. The results are shown in FIG. 10.

From the results, it was confirmed that in the case of adopting a rectangular lattice with a ratio of the length of "a₂" to the length of "a₁" of 1 : 1.2 (that is, in the case of adopting a rectangular lattice with a value of (a₂/a₁) of 1.2 which is within the range of not less than 1 and not more than 2 as the value of (a₂/a₁) indicating the ratio of the length of "a₂" to the length of "a₁" in FIG. 1), the extraction efficiency of laser light was dramatically improved, and in the case of (b₁'/b₁) = (b₂'/b₂) = 0.9, an extremely high extraction efficiency of laser light of 61.5% was obtained.

In this regard, it was also confirmed that this tendency was also applied to the case where the surface emitting quantum cascade lasers shown in FIGS. 2(a) and (b) were manufactured in a similar manner to Example 1-1 (not shown in a figure).

### Example 2-4

### <Effect of dopant amount>

As for the surface emitting quantum cascade lasers manufactured in a similar manner to Examples 1-1 and 1-2, the effect of laser light on the reabsorption was investigated.

In this regard, the reabsorption amount of laser light inside the surface emitting quantum cascade laser element was also numerically calculated by a finite element method. In this case, in consideration of only the main factors that determine the reabsorption of laser light (specifically, only the carriers caused by doping with dopants in semiconductor layers and the reabsorption of light by free electrons in a metal electrode on the upper surface), the reabsorption of light by intersubband transition in a multi-quantum well and free electrons in a back electrode, which did not substantially affect the reabsorption of laser light because of the relatively small contribution, was ignored.

The surface emitting quantum cascade lasers used for the numerical calculation had structures in which each unit lattice of photonic crystals 12, 22, and 32 was a square lattice in which both the lengths of "a₁" and "a₂" in FIG. 1 were the same 1.395 µm. In addition, the pentagonal shape of a bottom face of a pentagonal prism positioned in the central part of the unit lattice of a square lattice had a structure in which the value of (b₁'/b₁) indicating the ratio of the length of "b₁'" to the length of "b₁" in FIG. 1 was 0.4 and the value of (b₂'/b₂) indicating the ratio of the length of "b₂'" to the length of "b₂" in the FIG. was 0.8, and the lengths of "b₁" and "b₂" in the FIG. 1 were set so that the lengths of "b₁" and "b₂" were the same as each other and the pentagonal bottom face in the FIG. 1 was 50% of the unit lattice (square lattice). The doping densities of an InP layer and an InGaAs layer in the surface emitting quantum cascade laser were set to 4× 10¹⁶ cm⁻³.

In this regard, it was confirmed that when the doping density of a multi-quantum well layer in the surface emitting quantum cascade laser was reduced to one-fifth of from 2.5×10¹⁷ cm⁻³ to 5×10¹⁶ cm⁻³, the ratio of the reabsorption to the total laser light generation amount was reduced from 94.6% to 92.5% (not shown in a figure).

### INDUSTRIAL APPLICABILITY

The present invention can be used as a compact laser source that can cover a wavelength band from mid-infrared to far-infrared including a wavelength of 3 to 5 µm, and even to the extent of a terahertz region, and can also be used for various gas concentration measurements. Moreover, the concentration of the gas in a minute amount at a level of ppb can be measured, and because of having a characteristic of straightness, the present invention can be used for detecting a dangerous gas in a remote location such as a gas that comes from a volcano. Further, the present invention may be used to measure an isotope ratio by utilizing single-wavelength properties of a laser. For this reason, the present invention can be significantly expected to be useful in various fields (for example, environment, food, biotechnology, chemistry, pharmaceuticals, electronic devices, automobiles, and the like).

### REFERENCE SIGNS LIST

- 11, 31: "Metal electrode" (e.g., "Ti/Au electrode" or "Ni/Au electrode")
- 12, 22, 32: "Photonic crystal"
- 13, 23, 33: "Embedded InP cladding layer" or "Embedded Ti/Au metal layer"
- 14, 24, 34: "Active layer" (i.e., "Light-emitting layer")
- 15, 25, 35: "Lower cladding layer" (e.g., "InP cladding layer")
- 16, 26, 36: "Metal electrode" (e.g., "Ti/Au electrode" or "Ni/Au electrode")
- 27: "Upper cladding layer" (e.g., "InP cladding layer")
- 37: "InGaAs layer"
- 38: "InP substrate"
- 39: "Insulating film"

## Claims

1. A surface emitting quantum cascade laser, comprising:
semiconductor layers other than a laser active layer and the laser active layer (14, 24, 34); and
a square-lattice or rectangular-lattice photonic crystal (12, 22, 32) on the laser active layer (14, 24, 34),
wherein a unit lattice of the square-lattice or rectangular-lattice photonic crystal (12, 22, 32) is made of a composition A, and a composition B having a refractive index different from a refractive index of the composition A, and
wherein the composition A is a compound semiconductor composition or metal composition,
the composition B is a compound semiconductor composition, and
the unit lattice of the square-lattice or rectangular-lattice photonic crystal (12, 22, 32) has the following structure:
a columnar structure body having a square or rectangular bottom face and being made of the composition A is provided; and
a columnar structure body having a pentagonal bottom face and being made of the composition B is provided in a central part of the columnar structure body having the square or rectangular bottom face and being made of the composition A;
wherein the square or rectangular bottom face comprises a shape with a side length of "a₁" in a lateral direction and a side length of "a₂" in a longitudinal direction, and a ratio (a₂/a₁) of the side length (a₂) in the longitudinal direction to the side length (a₁) in the lateral direction is in the range of not less than 1 and not more than 2, and
a pentagonal shape of the pentagonal bottom face is a shape lacking a right triangle shape from one corner of a square or rectangle shape having a side length of "b₁" in a lateral direction and a side length of "b₂" in a longitudinal direction, and a ratio (b₂/b₁) of the side length (b₂) in the longitudinal direction to the side length (b₁) in the lateral direction is in a range of not less than 1 and not more than 2;
wherein the right triangle shape lacked from one corner of the square or rectangle shape having the side length of "b₁" in the lateral direction and the side length of "b₂" in the longitudinal direction is a shape with a base length of "b₁'" and a height of "b₂'" wherein the base length is a side length lacked from the side length of "b₁" in the lateral direction and the height is a side length lacked from the side length of "b₂" in the longitudinal direction,
wherein in a case where the photonic crystal is a rectangular-lattice photonic crystal,
a ratio (b₁'/b₁) of the base length (b₁') to the side length (b₁) in the lateral direction is not less than 0.1 and not more than 0.9, and a ratio (b₂'/b₂) of the height (b₂') to the side length (b₂) in the longitudinal direction is not less than 0.3 and not more than 0.9, and
wherein in a case where the photonic crystal is a square-lattice photonic crystal,
a ratio (b₁'/b₁) of the base length (b₁') to the side length (b₁) in the lateral direction is not less than 0.1 and not more than 0.5, and a ratio (b₂'/b₂) of the height (b₂') to the side length (b₂) in the longitudinal direction is not less than 0.3 and not more than 0.9.

2. The cascade laser according to claim 1, wherein a ratio of the columnar structure body having the pentagonal bottom face and being made of the composition B to the unit lattice of the square-lattice or rectangular-lattice photonic crystal is not less than 20% and not more than 80%.

3. The cascade laser according to claim 1 or claim 2, wherein the laser active layer (14, 24, 34) is a multi-quantum well comprising not less than two quantum well layers, each of which contains any one of a group III-V compound semiconductor composition, a compound semiconductor composition made of ZnO and ZnMgO, or a compound semiconductor composition made of Si and SiGe.

4. The cascade laser according to claim 3, wherein the group III-V compound semiconductor composition is at least one selected from the group consisting of a compound semiconductor composition made of InGaAs and AlInAs, a compound semiconductor composition made of GaAs and InGaAs, a compound semiconductor composition made of GaAs and AlGaAs, a compound semiconductor composition made of InAs and AlGaSb, a compound semiconductor composition made of GaN and AlGaN, and a compound semiconductor composition made of GaN and InGaN.

5. The cascade laser according to any one of claims 1 to 4, wherein a doping density of the laser active layer (14, 24, 34) is not more than 1×10¹⁸ cm⁻³, and a doping density of the semiconductor layers other than the laser active layer is not more than 1 × 10¹⁹ cm⁻³.

6. The cascade laser according to any one of claims 1 to 5, wherein a laser oscillation wavelength is not less than 3 µm and not more than 9 µm.

7. The cascade laser according to any one of claims 1 to 6, wherein the composition A and/or the composition B comprises a group III-V compound semiconductor composition.

8. The cascade laser according to claim 7, wherein the group III-V compound semiconductor composition is at least one compound semiconductor composition selected from the group consisting of InP, InGaAs, GaAs, AlGaAs, GaInP, InAs, AlInAs, and GaP.

9. The cascade laser according to any one of claims 1 to 8, wherein the composition A is an InP compound semiconductor composition or metal composition, and the composition B is an InGaAs compound semiconductor composition.

10. The cascade laser according to any one of claims 1 to 9, wherein the composition A is a metal composition.

11. The cascade laser according to any one of claims 1 to 10, wherein the metal composition comprises gold as a main component.

12. A surface emitting quantum cascade laser, comprising:
semiconductor layers other than a laser active layer and the laser active layer (14, 24, 34); and
a square-lattice or rectangular-lattice photonic crystal (12, 22, 32) on the laser active layer (14, 24, 34),
wherein a unit lattice of the square-lattice or rectangular-lattice photonic crystal (12, 22, 32) is made of a composition A, a composition B having a refractive index different from a refractive index of the composition A, and a composition C having a refractive index different from both refractive indexes of the compositions A and B, and
wherein the composition A is a compound semiconductor composition or metal composition,
the composition B is a compound semiconductor composition,
the composition C is a dielectric composition, and
the unit lattice of the square-lattice or rectangular-lattice photonic crystal (12, 22, 32) has the following structure:
a columnar structure body having a square or rectangular bottom face and being made of the composition A is provided on a layer made of the composition B;
a columnar structure body having a pentagonal bottom face and being made of the composition C is provided in a central part of the columnar structure body having the square or rectangular bottom face and being made of the composition A, and the pentagonal bottom face of the columnar structure body having the pentagonal bottom face and being made of the composition C is positioned on the layer made of the composition B; and
the columnar structure body having the pentagonal bottom face and being made of the composition C is embedded in the columnar structure body having the square or rectangular bottom face and being made of the composition A;
wherein the square or rectangular bottom face comprises a shape with a side length of "a₁" in a lateral direction and a side length of "a₂" in a longitudinal direction, and a ratio (a₂/a₁) of the side length (a₂) in the longitudinal direction to the side length (a₁) in the lateral direction is in the range of not less than 1 and not more than 2, and
a pentagonal shape of the pentagonal bottom face is a shape lacking a right triangle shape from one corner of a square or rectangle shape having a side length of "b₁" in a lateral direction and a side length of "b₂" in a longitudinal direction, and a ratio (b₂/b₁) of the side length (b₂) in the longitudinal direction to the side length (b₁) in the lateral direction is in a range of not less than 1 and not more than 2;
wherein the right triangle shape lacked from one corner of the square or rectangle shape having the side length of "b₁" in the lateral direction and the side length of "b₂" in the longitudinal direction is a shape with a base length of "b₁'" and a height of "b₂'" wherein the base length is a side length lacked from the side length of "b₁" in the lateral direction and the height is a side length lacked from the side length of "b₂" in the longitudinal direction,
wherein in a case where the photonic crystal is a rectangular-lattice photonic crystal,
a ratio (b₁'/b₁) of the base length (b₁') to the side length (b₁) in the lateral direction is not less than 0.1 and not more than 0.9, and a ratio (b₂'/b₂) of the height (b₂') to the side length (b₂) in the longitudinal direction is not less than 0.3 and not more than 0.9, and
wherein in a case where the photonic crystal is a square-lattice photonic crystal,
a ratio (b₁'/b₁) of the base length (b₁') to the side length (b₁) in the lateral direction is not less than 0.1 and not more than 0.5, and a ratio (b₂'/b₂) of the height (b₂') to the side length (b₂) in the longitudinal direction is not less than 0.3 and not more than 0.9.

13. A surface emitting quantum cascade laser, comprising:
semiconductor layers other than a laser active layer and the laser active layer (14, 24, 34); and
a square-lattice or rectangular-lattice photonic crystal (12, 22, 32) on the laser active layer (14, 24, 34),
wherein a unit lattice of the square-lattice or rectangular-lattice photonic crystal (12, 22, 32) is made of a composition A, and a composition B having a refractive index different from a refractive index of the composition A,
wherein the composition A is a compound semiconductor composition or a metal composition,
the composition B is a compound semiconductor composition, and
the unit lattice of the square-lattice or rectangular-lattice photonic crystal (12, 22, 32) has the following structure:
a columnar structure body having a square or rectangular bottom face and being made of the composition A is provided on a layer made of the composition B;
a spatial columnar structure body having a pentagonal bottom face is provided as a vacant space in a central part of the columnar structure body having the square or rectangular bottom face and being made of the composition A, and the bottom face of the spatial columnar structure body is positioned on the layer made of the composition B; and
the spatial columnar structure body is embedded in the columnar structure body having the square or rectangular bottom face and being made of the composition A;
wherein the square or rectangular bottom face comprises a shape with a side length of "a₁" in a lateral direction and a side length of "a₂" in a longitudinal direction, and a ratio (a₂/a₁) of the side length (a₂) in the longitudinal direction to the side length (a₁) in the lateral direction is in the range of not less than 1 and not more than 2, and
a pentagonal shape of the pentagonal bottom face is a shape lacking a right triangle shape from one corner of a square or rectangle shape having a side length of "b₁" in a lateral direction and a side length of "b₂" in a longitudinal direction, and a ratio (b₂/b₁) of the side length (b₂) in the longitudinal direction to the side length (b₁) in the lateral direction is in a range of not less than 1 and not more than 2;
wherein the right triangle shape lacked from one corner of the square or rectangle shape having the side length of "b₁" in the lateral direction and the side length of "b₂" in the longitudinal direction is a shape with a base length of "b₁'" and a height of "b₂'" wherein the base length is a side length lacked from the side length of "b₁" in the lateral direction and the height is a side length lacked from the side length of "b₂" in the longitudinal direction,
wherein in a case where the photonic crystal is a rectangular-lattice photonic crystal,
a ratio (b₁'/b₁) of the base length (b₁') to the side length (b₁) in the lateral direction is not less than 0.1 and not more than 0.9, and a ratio (b₂'/b₂) of the height (b₂') to the side length (b₂) in the longitudinal direction is not less than 0.3 and not more than 0.9, and
wherein in a case where the photonic crystal is a square-lattice photonic crystal,
a ratio (b₁'/b₁) of the base length (b₁') to the side length (b₁) in the lateral direction is not less than 0.1 and not more than 0.5, and a ratio (b₂'/b₂) of the height (b₂') to the side length (b₂) in the longitudinal direction is not less than 0.3 and not more than 0.9.

## Patentansprüche

1. Oberflächenemittierender Quantenkaskadenlaser, umfassend:
Halbleiterschichten, die sich von einer laseraktiven Schicht und der laseraktiven Schicht (14, 24, 34) unterscheiden; und
einen photonischen Kristall mit quadratischem Gitter oder rechteckigem Gitter (12, 22, 32) auf der laseraktiven Schicht (14, 24, 34),
wobei ein Einheitsgitter des photonischen Kristalls mit quadratischem Gitter oder rechteckigem Gitter (12, 22, 32) aus einer Zusammensetzung A und einer Zusammensetzung B mit einem Brechungsindex, der sich von einem Brechungsindex der Zusammensetzung A unterscheidet, hergestellt ist, und
wobei die Zusammensetzung A eine Verbindungshalbleiter-Zusammensetzung oder eine Metallzusammensetzung ist,
die Zusammensetzung B eine Verbindungshalbleiter-Zusammensetzung ist, und
das Einheitsgitter des photonischen Kristalls mit quadratischem Gitter oder rechteckigem Gitter (12, 22, 32) folgende Struktur aufweist:
ein säulenförmiger Strukturkörper, der eine quadratische oder rechteckige Bodenfläche hat und aus der Zusammensetzung A hergestellt ist, wird bereitgestellt; und
ein säulenförmiger Strukturkörper, der eine fünfeckige Bodenfläche hat und aus der Zusammensetzung B hergestellt ist, wird in einem zentralen Teil des säulenförmigen Strukturkörpers mit der quadratischen oder rechteckigen Bodenfläche, der aus der Zusammensetzung A hergestellt ist, bereitgestellt;
wobei die quadratische oder rechteckige Bodenfläche eine Form mit einer Seitenlänge von "a₁" in einer Querrichtung und einer Seitenlänge von "a₂" in einer Längsrichtung umfasst, und ein Verhältnis (a₂/a₁) der Seitenlänge (a₂) in der Längsrichtung zu der Seitenlänge (a₁) in der Querrichtung im Bereich von nicht weniger als 1 und nicht mehr als 2 liegt, und
eine fünfeckige Form der fünfeckigen Bodenfläche eine Form ist, der die Form eines rechtwinkligen Dreiecks von einer Ecke einer Quadrat- oder Rechteckform fehlt, die eine Seitenlänge von "b₁" in einer seitlichen Richtung und eine Seitenlänge von "b₂" in einer Längsrichtung hat, und ein Verhältnis (b₂/b₁) der Seitenlänge (b₂) in der Längsrichtung zu der Seitenlänge (b₁) in der Querrichtung in einem Bereich von nicht weniger als 1 und nicht mehr als 2 liegt;
wobei die Form des rechtwinkligen Dreiecks, die von einer Ecke der quadratischen oder rechteckigen Form mit der Seitenlänge von "b₁" in der Querrichtung und der Seitenlänge von "b₂" in der Längsrichtung fehlt, eine Form mit einer Basislänge von "b₁" und einer Höhe von "b₂" ist, wobei die Basislänge eine Seitenlänge ist, die von der Seitenlänge von "b₁" in der seitlichen Richtung fehlt, und die Höhe eine Seitenlänge ist, die von der Seitenlänge von "b₂" in der Längsrichtung fehlt,
wobei in einem Fall, in dem der photonische Kristall ein photonischer Kristall mit rechteckigem Gitter ist,
ein Verhältnis (b₁'/b₁) der Basislänge (b₁') zu der Seitenlänge (b₁) in der lateralen Richtung nicht weniger als 0,1 und nicht mehr als 0,9 beträgt, und ein Verhältnis (b₂'/b₂) der Höhe (b₂') zu der Seitenlänge (b₂) in der Längsrichtung nicht weniger als 0,3 und nicht mehr als 0,9 beträgt, und
wobei in einem Fall, in dem der photonische Kristall ein photonischer Kristall mit quadratischem Gitter ist,
ein Verhältnis (b₁'/b₁) der Basislänge (b₁') zu der Seitenlänge (b₁) in der lateralen Richtung nicht weniger als 0,1 und nicht mehr als 0,5 beträgt, und ein Verhältnis (b₂'/b₂) der Höhe (b₂') zu der Seitenlänge (b₂) in der Längsrichtung nicht weniger als 0,3 und nicht mehr als 0,9 beträgt.

2. Kaskadenlaser nach Anspruch 1, wobei das Verhältnis des säulenförmigen Strukturkörpers, der die fünfeckige Bodenfläche aufweist und aus der Zusammensetzung B besteht, zum Einheitsgitter des photonischen Kristalls mit quadratischem Gitter oder rechteckigem Gitter nicht weniger als 20 % und nicht mehr als 80 % beträgt.

3. Kaskadenlaser nach Anspruch 1 oder Anspruch 2, wobei die laseraktive Schicht (14, 24, 34) ein Multi-Quantum-Well ist, der nicht weniger als zwei Quantum-Well-Schichten umfasst, von denen jede eines der Folgenden enthält: eine Verbindungshalbleiter-Zusammensetzung der Gruppe III-V, eine Verbindungshalbleiter-Zusammensetzung aus ZnO und ZnMgO oder eine Verbindungshalbleiter-Zusammensetzung aus Si und SiGe.

4. Kaskadenlaser nach Anspruch 3, wobei die Gruppe III-V-Verbindungshalbleiter-Zusammensetzung mindestens eine ist, die aus der Gruppe ausgewählt ist, die aus Folgendem besteht: einer Verbindungshalbleiter-Zusammensetzung aus InGaAs und AllnAs, einer Verbindungshalbleiter-Zusammensetzung aus GaAs und InGaAs, einer Verbindungshalbleiter-Zusammensetzung aus GaAs und AlGaAs, einer Verbindungshalbleiter-Zusammensetzung aus InAs und AlGaSb, einer Verbindungshalbleiter-Zusammensetzung aus GaN und AlGaN und einer Verbindungshalbleiter-Zusammensetzung aus GaN und InGaN.

5. Kaskadenlaser nach einem der Ansprüche 1 bis 4, wobei eine Dotierungsdichte der laseraktiven Schicht (14, 24, 34) nicht mehr als 1 × 10¹⁸ cm⁻³ beträgt und eine Dotierungsdichte der anderen Halbleiterschichten als der laseraktiven Schicht nicht mehr als 1 × 10¹⁹ cm⁻³ beträgt.

6. Kaskadenlaser nach einem der Ansprüche 1 bis 5, wobei eine Laseroszillationswellenlänge nicht weniger als 3 µm und nicht mehr als 9 µm beträgt.

7. Kaskadenlaser nach einem der Ansprüche 1 bis 6, wobei die Zusammensetzung A und/oder die Zusammensetzung B eine Verbindungshalbleiter-Zusammensetzung der Gruppe III-V umfasst.

8. Kaskadenlaser nach Anspruch 7, wobei die Verbindungshalbleiter-Zusammensetzung der Gruppe III-V mindestens eine Verbindungshalbleiter-Zusammensetzung ist, die aus der Gruppe bestehend aus InP, InGaAs, GaAs, AlGaAs, GalnP, InAs, AllnAs und GaP ausgewählt ist.

9. Kaskadenlaser nach einem der Ansprüche 1 bis 8, wobei die Zusammensetzung A eine InP-Verbindungshalbleiter-Zusammensetzung oder eine Metallzusammensetzung und die Zusammensetzung B eine InGaAs-Verbindungshalbleiter-Zusammensetzung ist.

10. Kaskadenlaser nach einem der Ansprüche 1 bis 9, wobei die Zusammensetzung A eine Metallzusammensetzung ist.

11. Kaskadenlaser nach einem der Ansprüche 1 bis 10, wobei die Metallzusammensetzung Gold als eine Hauptkomponente umfasst.

12. Oberflächenemittierender Quantenkaskadenlaser, umfassend:
Halbleiterschichten, die sich von einer laseraktiven Schicht und der laseraktiven Schicht (14, 24, 34) unterscheiden; und
einen photonischen Kristall mit quadratischem Gitter oder rechteckigem Gitter (12, 22, 32) auf der laseraktiven Schicht (14, 24, 34),
wobei ein Einheitsgitter des photonischen Kristalls mit quadratischem Gitter oder rechteckigem Gitter (12, 22, 32) aus einer Zusammensetzung A und einer Zusammensetzung B mit einem Brechungsindex, der sich von einem Brechungsindex der Zusammensetzung A unterscheidet, und einer Zusammensetzung C mit einem Brechungsindex, der sich von beiden Brechungsindizes der Zusammensetzungen A und B unterscheidet, hergestellt ist, und
wobei die Zusammensetzung A eine Verbindungshalbleiter-Zusammensetzung oder eine Metallzusammensetzung ist,
die Zusammensetzung B eine Verbindungshalbleiter-Zusammensetzung ist,
die Zusammensetzung C eine dielektrische Zusammensetzung ist, und
das Einheitsgitter des photonischen Kristalls mit quadratischem Gitter oder rechteckigem Gitter (12, 22, 32) folgende Struktur aufweist:
ein säulenförmiger Strukturkörper, der eine quadratische oder rechteckige Bodenfläche hat und aus der Zusammensetzung A hergestellt ist, ist auf einer Schicht aus der Zusammensetzung B bereitgestellt;
ein säulenförmiger Strukturkörper, der eine fünfeckige Bodenfläche hat und aus der Zusammensetzung C hergestellt ist, wird in einem zentralen Teil des säulenförmigen Strukturkörpers mit der quadratischen oder rechteckigen Bodenfläche, der aus der Zusammensetzung A hergestellt ist, bereitgestellt, und die fünfeckige Bodenfläche des säulenförmigen Strukturkörpers, der die fünfeckige Bodenfläche aufweist und aus der Zusammensetzung C besteht, ist auf der Schicht aus der Zusammensetzung B angeordnet; und
der säulenförmige Strukturkörper mit der fünfeckigen Bodenfläche, der aus der Zusammensetzung C hergestellt ist, ist in den säulenförmigen Strukturkörper mit der quadratischen oder rechteckigen Bodenfläche, der aus der Zusammensetzung A hergestellt ist, eingebettet,
wobei die quadratische oder rechteckige Bodenfläche eine Form mit einer Seitenlänge von "a₁" in einer Querrichtung und einer Seitenlänge von "a₂" in einer Längsrichtung umfasst, und ein Verhältnis (a₂/a₁) der Seitenlänge (a₂) in der Längsrichtung zu der Seitenlänge (a₁) in der Querrichtung im Bereich von nicht weniger als 1 und nicht mehr als 2 liegt, und
eine fünfeckige Form der fünfeckigen Bodenfläche eine Form ist, der die Form eines rechtwinkligen Dreiecks von einer Ecke einer Quadrat- oder Rechteckform fehlt, die eine Seitenlänge von "b₁" in einer seitlichen Richtung und eine Seitenlänge von "b₂" in einer Längsrichtung hat, und ein Verhältnis (b₂/b₁) der Seitenlänge (b₂) in der Längsrichtung zu der Seitenlänge (b₁) in der Querrichtung in einem Bereich von nicht weniger als 1 und nicht mehr als 2 liegt;
wobei die Form des rechtwinkligen Dreiecks, die von einer Ecke der quadratischen oder rechteckigen Form mit der Seitenlänge von "b₁" in der Querrichtung und der Seitenlänge von "b₂" in der Längsrichtung fehlt, eine Form mit einer Basislänge von "b₁" und einer Höhe von "b₂" ist, wobei die Basislänge eine Seitenlänge ist, die von der Seitenlänge von "b₁" in der seitlichen Richtung fehlt, und die Höhe eine Seitenlänge ist, die von der Seitenlänge von "b₂" in der Längsrichtung fehlt,
wobei in einem Fall, in dem der photonische Kristall ein photonischer Kristall mit rechteckigem Gitter ist,
ein Verhältnis (b₁'/b₁) der Basislänge (b₁') zu der Seitenlänge (b₁) in der lateralen Richtung nicht weniger als 0,1 und nicht mehr als 0,9 beträgt, und ein Verhältnis (b₂'/b₂) der Höhe (b₂') zu der Seitenlänge (b₂) in der Längsrichtung nicht weniger als 0,3 und nicht mehr als 0,9 beträgt, und
wobei in einem Fall, in dem der photonische Kristall ein photonischer Kristall mit quadratischem Gitter ist,
ein Verhältnis (b₁'/b₁) der Basislänge (b₁') zu der Seitenlänge (b₁) in der lateralen Richtung nicht weniger als 0,1 und nicht mehr als 0,5 beträgt, und ein Verhältnis (b₂'/b₂) der Höhe (b₂') zu der Seitenlänge (b₂) in der Längsrichtung nicht weniger als 0,3 und nicht mehr als 0,9 beträgt.

13. Oberflächenemittierender Quantenkaskadenlaser, umfassend:
Halbleiterschichten, die sich von einer laseraktiven Schicht und der laseraktiven Schicht (14, 24, 34) unterscheiden; und
einen photonischen Kristall mit quadratischem Gitter oder rechteckigem Gitter (12, 22, 32) auf der laseraktiven Schicht (14, 24, 34),
wobei ein Einheitsgitter des photonischen Kristalls mit quadratischem Gitter oder rechteckigem Gitter (12, 22, 32) aus einer Zusammensetzung A und einer Zusammensetzung B mit einem Brechungsindex, der sich von einem Brechungsindex der Zusammensetzung A unterscheidet, hergestellt ist,
wobei die Zusammensetzung A eine Verbindungshalbleiter-Zusammensetzung oder eine Metallzusammensetzung ist,
die Zusammensetzung B eine Verbindungshalbleiter-Zusammensetzung ist, und
das Einheitsgitter des photonischen Kristalls mit quadratischem Gitter oder rechteckigem Gitter (12, 22, 32) folgende Struktur aufweist:
ein säulenförmiger Strukturkörper, der eine quadratische oder rechteckige Bodenfläche hat und aus der Zusammensetzung A hergestellt ist, ist auf einer Schicht aus der Zusammensetzung B bereitgestellt;
ein räumlicher säulenförmiger Strukturkörper, der eine fünfeckige Bodenfläche hat und als freier Raum in einem zentralen Teil des säulenförmigen Strukturkörpers mit der quadratischen oder rechteckigen Bodenfläche, der aus der Zusammensetzung A hergestellt ist, ist bereitgestellt, und die Bodenfläche des räumlichen säulenförmigen Strukturkörpers ist auf der Schicht aus der Zusammensetzung B angeordnet; und
der räumliche säulenförmige Strukturkörper ist in den säulenförmigen Strukturkörper eingebettet, der die quadratische oder rechteckige Bodenfläche aufweist und aus der Zusammensetzung A hergestellt ist;
wobei die quadratische oder rechteckige Bodenfläche eine Form mit einer Seitenlänge von "a₁" in einer Querrichtung und einer Seitenlänge von "a₂" in einer Längsrichtung umfasst, und ein Verhältnis (a₂/a₁) der Seitenlänge (a₂) in der Längsrichtung zu der Seitenlänge (a₁) in der Querrichtung im Bereich von nicht weniger als 1 und nicht mehr als 2 liegt, und
eine fünfeckige Form der fünfeckigen Bodenfläche eine Form ist, der die Form eines rechtwinkligen Dreiecks von einer Ecke einer Quadrat- oder Rechteckform fehlt, die eine Seitenlänge von "b₁" in einer seitlichen Richtung und eine Seitenlänge von "b₂" in einer Längsrichtung hat, und ein Verhältnis (b₂/b₁) der Seitenlänge (b₂) in der Längsrichtung zu der Seitenlänge (b₁) in der Querrichtung in einem Bereich von nicht weniger als 1 und nicht mehr als 2 liegt,
wobei die Form des rechtwinkligen Dreiecks, die von einer Ecke der quadratischen oder rechteckigen Form mit der Seitenlänge von "b₁" in der Querrichtung und der Seitenlänge von "b₂" in der Längsrichtung fehlt, eine Form mit einer Basislänge von "b₁'" und einer Höhe von "b₂'" ist, wobei die Basislänge eine Seitenlänge ist, die von der Seitenlänge von "b₁" in der seitlichen Richtung fehlt, und die Höhe eine Seitenlänge ist, die von der Seitenlänge von "b₂" in der Längsrichtung fehlt,
wobei in einem Fall, in dem der photonische Kristall ein photonischer Kristall mit rechteckigem Gitter ist,
ein Verhältnis (b₁'/b₁) der Basislänge (b₁') zu der Seitenlänge (b₁) in der lateralen Richtung nicht weniger als 0,1 und nicht mehr als 0,9 beträgt, und ein Verhältnis (b₂'/b₂) der Höhe (b₂') zu der Seitenlänge (b₂) in der Längsrichtung nicht weniger als 0,3 und nicht mehr als 0,9 beträgt, und
wobei in einem Fall, in dem der photonische Kristall ein photonischer Kristall mit quadratischem Gitter ist,
ein Verhältnis (b₁'/b₁) der Basislänge (b₁') zu der Seitenlänge (b₁) in der lateralen Richtung nicht weniger als 0,1 und nicht mehr als 0,5 beträgt, und ein Verhältnis (b₂'/b₂) der Höhe (b₂') zu der Seitenlänge (b₂) in der Längsrichtung nicht weniger als 0,3 und nicht mehr als 0,9 beträgt.

## Revendications

1. Laser à cascade quantique à émission de surface, comprenant :
des couches semi-conductrices autres qu'une couche active de laser et la couche active de laser (14, 24, 34) ; et
un cristal photonique à réseau carré ou à réseau rectangulaire (12, 22, 32) sur la couche active de laser (14, 24, 34),
dans lequel un réseau unitaire du cristal photonique à réseau carré ou à réseau rectangulaire (12, 22, 32) est constitué d'une composition A ,et d'une composition B ayant un indice de réfraction différent d'un indice de réfraction de la composition A, et
dans lequel la composition A est une composition semi-conductrice composée ou une composition métallique,
la composition B est une composition semi-conductrice composée, et
le réseau unitaire du cristal photonique à réseau carré ou à réseau rectangulaire (12, 22, 32) a la structure suivante :
un corps de structure colonnaire ayant une face inférieure carrée ou rectangulaire et constitué de la composition A est fourni ; et
un corps de structure colonnaire ayant une face inférieure pentagonale et constitué de la composition B est fourni dans une partie centrale du corps de structure colonnaire ayant la face inférieure carrée ou rectangulaire et constitué de la composition A ;
dans lequel la face inférieure carrée ou rectangulaire comprend une forme avec une longueur de côté de « a₁ » dans une direction latérale et une longueur de côté de « a₂ » dans une direction longitudinale, et un rapport (a₂/a₁) entre la longueur de côté (a₂) dans la direction longitudinale et la longueur de côté (a₁) dans la direction latérale est dans la plage non inférieure à 1 et non supérieure à 2, et
une forme pentagonale de la face inférieure pentagonale est une forme à laquelle il manque une forme de triangle droit à un coin d'une forme de carré ou de rectangle ayant une longueur de côté de « b₁ » dans une direction latérale et une longueur de côté de « b₂ » dans une direction longitudinale, et un rapport (b₂/b₁) entre la longueur de côté (b₂) dans la direction longitudinale et la longueur de côté (b₁) dans la direction latérale est dans une plage non inférieure 1 et non supérieure à 2 ;
dans lequel la forme de triangle droit manquant à un coin d'une forme de carré ou de rectangle ayant la longueur de côté de « b₁ » dans la direction latérale et la longueur de côté de « b₂ » dans la direction longitudinale est une forme avec une longueur de base de « bi' » et une hauteur de « b₂' » dans lequel la longueur de base est une longueur de côté manquant à la longueur de côté de « b₁ » dans la direction latérale et la hauteur est une longueur de côté manquant à la longueur de côté de « b₂ » dans la direction longitudinale,
dans lequel dans un cas où le cristal photonique est un cristal photonique à réseau rectangulaire,
un rapport (b₁'/b₁) entre la longueur de base (b₁') et la longueur de côté (b₁) dans la direction latérale est non inférieur à 0,1 et non supérieur à 0,9, et un rapport (b₂'/b₂) entre la hauteur (b₂') et la longueur de côté (b₂) dans la direction longitudinale est non inférieur à 0,3 et non supérieur à 0,9, et
dans lequel dans un cas où le cristal photonique est un cristal photonique à réseau carré,
un rapport (b₁'/b₁) entre la longueur de base (b₁') et la longueur de côté (b₁) dans la direction latérale est non inférieur à 0,1 et non supérieur à 0,5, et un rapport (b₂'/b₂) entre la hauteur (b₂') et la longueur de côté (b₂) dans la direction longitudinale est non inférieur à 0,3 et non supérieur à 0,9.

2. Laser à cascade selon la revendication 1, dans lequel un rapport entre le corps de structure colonnaire ayant la face inférieure pentagonale et étant constitué de la composition B et le réseau unitaire du cristal photonique à réseau carré ou à réseau rectangulaire est non inférieur à 20 % et non supérieur à 80 %.

3. Laser à cascade selon la revendication 1 ou la revendication 2, dans lequel la couche active de laser (14, 24, 34) est un puits quantique multiple comprenant pas moins de deux couches de puits quantique, dont chacune contient l'une quelconque parmi une composition semi-conductrice composée de groupe III-V, une composition semi-conductrice composée constituée de ZnO et de ZnMgO, ou une composition semi-conductrice composée constituée de Si et de SiGe.

4. Laser à cascade selon la revendication 3, dans lequel la composition semi-conductrice composée de groupe III-V est au moins l'une sélectionnée dans le groupe constitué d'une composition semi-conductrice composée constituée d'InGaAs et d'A1InAs, d'une composition semi-conductrice composée constituée de GaAs et d'InGaAs, d'une composition semi-conductrice composée constituée de GaAs et d'A1GaAs, d'une composition semi-conductrice composée constituée d'InAs et d'A1GaSb, d'une composition semi-conductrice composée constituée de GaN et d'A1GaN, et d'une composition semi-conductrice composée constituée de GaN et d'InGaN.

5. Laser à cascade selon l'une quelconque des revendications 1 à 4, dans lequel une densité de dopage de la couche active de laser (14, 24, 34) est non supérieure à 1×10¹⁸ cm⁻³, et la densité de dopage des couches semi-conductrices autres que la couche active de laser est non supérieure à 1×10¹⁹ cm⁻³.

6. Laser à cascade selon l'une quelconque des revendications 1 à 5, dans lequel une longueur d'onde d'oscillation de laser est non inférieure à 3 µm et non supérieure à 9 µm.

7. Laser à cascade selon l'une quelconque des revendications 1 à 6, dans lequel la composition A et/ou la composition B comprennent une composition semi-conductrice composée de groupe III-V.

8. Laser à cascade selon la revendication 7, dans lequel la composition semi-conductrice composée de groupe III-V est au moins une composition semi-conductrice composée sélectionnée dans le groupe constitué par InP, InGaAs, GaAs, A1GaAs, GalnP, InAs, A1InAs, et GaP.

9. Laser à cascade selon l'une quelconque des revendications 1 à 8, dans lequel la composition A est une composition semi-conductrice composée d'InP ou une composition métallique, et la composition B est une composition semi-conductrice composée d'InGaAs.

10. Laser à cascade selon l'une quelconque des revendications 1 à 9, dans lequel la composition A est une composition métallique.

11. Laser à cascade selon l'une quelconque des revendications 1 à 10, dans lequel la composition métallique comprend de l'or comme composant principal.

12. Laser à cascade quantique à émission de surface, comprenant :
des couches semi-conductrices autres qu'une couche active de laser et la couche active de laser (14, 24, 34) ; et
un cristal photonique à réseau carré ou à réseau rectangulaire (12, 22, 32) sur la couche active de laser (14, 24, 34),
dans lequel un réseau unitaire du cristal photonique à réseau carré ou à réseau rectangulaire (12, 22, 32) est constitué d'une composition A, d'une composition B ayant un indice de réfraction différent d'un indice de réfraction de la composition A, et d'une composition C ayant un indice de réfraction différent des deux indices de réfraction des compositions A et B, et
dans lequel la composition A est une composition semi-conductrice composée ou une composition métallique,
la composition B est une composition semi-conductrice composée,
la composition C est une composition diélectrique, et
le réseau unitaire du cristal photonique à réseau carré ou à réseau rectangulaire (12, 22, 32) a la structure suivante :
un corps de structure colonnaire ayant une face inférieure carrée ou rectangulaire et constitué de la composition A est fourni sur une couche constituée de la composition B ;
un corps de structure colonnaire ayant une face inférieure pentagonale et constitué de la composition C est fourni dans une partie centrale du corps de structure colonnaire ayant la face inférieure carrée ou rectangulaire et constitué de la composition A, et la face inférieure pentagonale du corps de structure colonnaire ayant la face inférieure pentagonale et constitué de la composition C est positionnée sur la couche constituée de la composition B ; et
le corps de structure colonnaire ayant la face inférieure pentagonale et constitué de la composition C est encastré dans le corps de structure colonnaire ayant la face inférieure carrée ou rectangulaire et constitué de la composition A ;
dans lequel la face inférieure carrée ou rectangulaire comprend une forme avec une longueur de côté de « a₁ » dans une direction latérale et une longueur de côté de « a₂ » dans une direction longitudinale, et un rapport (a₂/a₁) entre la longueur de côté (a₂) dans la direction longitudinale et la longueur de côté (a₁) dans la direction latérale est dans la plage non inférieure à 1 et non supérieure à 2, et
une forme pentagonale de la face inférieure pentagonale est une forme à laquelle il manque une forme de de triangle droit à un coin d'une forme de carré ou de rectangle ayant une longueur de côté de « b₁ » dans une direction latérale et une longueur de côté de « b₂ » dans une direction longitudinale, et un rapport (b₂/b₁) entre la longueur de côté (b₂) dans la direction longitudinale et la longueur de côté (b₁) dans la direction latérale est dans une plage non inférieure à 1 et non supérieure à 2 ;
dans lequel la forme de triangle droit manquant à un coin d'une forme de carré ou de rectangle ayant la longueur de côté de « b₁ » dans la direction latérale et la longueur de côté de « b₂ » dans la direction longitudinale est une forme avec une longueur de base de « bi' » et une hauteur de « b₂' » dans lequel la longueur de base est une longueur de côté manquant à la longueur de côté de « b₁ » dans la direction latérale et la hauteur est une longueur de côté manquant à la longueur de côté de « b₂ » dans la direction longitudinale,
dans lequel dans un cas où le cristal photonique est un cristal photonique à réseau rectangulaire,
un rapport (b₁'/b₁) entre la longueur de base (b₁') et la longueur de côté (b₁) dans la direction latérale est non inférieur à 0,1 et non supérieur à 0,9, et un rapport (b₂'/b₂) entre la hauteur (b₂') et la longueur de côté (b₂) dans la direction longitudinale est non inférieur à 0,3 et non supérieur à 0,9, et
dans lequel dans un cas où le cristal photonique est un cristal photonique à réseau carré,
un rapport (b₁'/b₁) entre la longueur de base (b₁') et la longueur de côté (b₁) dans la direction latérale est non inférieur à 0,1 et non supérieur à 0,5, et un rapport (b₂'/b₂) entre la hauteur (b₂') et la longueur de côté (b₂) dans la direction longitudinale est non inférieur à 0,3 et non supérieur à 0,9.

13. Laser à cascade quantique à émission de surface, comprenant :
des couches semi-conductrices autres qu'une couche active de laser et la couche active de laser (14, 24, 34) ; et
un cristal photonique à réseau carré ou à réseau rectangulaire (12, 22, 32) sur la couche active de laser (14, 24, 34),
dans lequel un réseau unitaire du cristal photonique à réseau carré ou à réseau rectangulaire (12, 22, 32) est constituée d'une composition A, et d'une composition B ayant un indice de réfraction différent d'un indice de réfraction de la composition A,
dans lequel la composition A est une composition semi-conductrice composée ou une composition métallique,
la composition B est une composition semi-conductrice composée, et
le réseau unitaire du cristal photonique à réseau carré ou à réseau rectangulaire (12, 22, 32) a la structure suivante :
un corps de structure colonnaire ayant une face inférieure carrée ou rectangulaire et constitué de la composition A est fourni sur une couche constituée de la composition B ;
un corps de structure colonnaire spatiale ayant une face inférieure pentagonale est fourni en tant qu'espace vacant dans une partie centrale du corps de structure colonnaire ayant la face inférieure carrée ou rectangulaire et constitué de la composition A, et la face inférieure du corps de structure colonnaire spatiale est positionnée sur la couche constituée de la composition B ; et
le corps de structure colonnaire spatiale est encastré dans le corps de structure colonnaire ayant la face inférieure carrée ou rectangulaire et constitué de la composition A ;
dans lequel la face inférieure carrée ou rectangulaire comprend une forme avec une longueur de côté de « a₁ » dans une direction latérale et une longueur de côté de « a₂ » dans une direction longitudinale, et un rapport (a₂/a₁) entre la longueur de côté (a₂) dans la direction longitudinale et la longueur de côté (a₁) dans la direction latérale est dans la plage non inférieure à 1 et non supérieure à 2, et
une forme pentagonale de la face inférieure pentagonale est une forme à laquelle il manque une forme de triangle droit à un coin d'une forme de carré ou de rectangle ayant une longueur de côté de «b₁ » dans une direction latérale et une longueur de côté de « b₂ » dans une direction longitudinale, et un rapport (b₂/b₁) entre la longueur de côté (b₂) dans la direction longitudinale et la longueur de côté (b₁) dans la direction latérale est dans une plage non inférieure à 1 et non supérieure à 2 ;
dans lequel la forme de triangle droit manquant à un coin de la forme de carré ou de rectangle ayant la longueur de côté de « b₁ » dans la direction latérale et la longueur de côté de « b₂ » dans la direction longitudinale est une forme avec une longueur de base de « bi' » et une hauteur de « b₂' » dans lequel la longueur de base est une longueur de côté manquant à la longueur de côté de « b₁ » dans la direction latérale et la hauteur est une longueur de côté manquant à la longueur de côté de « b₂ » dans la direction longitudinale,
dans lequel dans un cas où le cristal photonique est un cristal photonique à réseau rectangulaire,
un rapport (b₁'/b₁) entre la longueur de base (b₁') et la longueur de côté (b₁) dans la direction latérale est non inférieur à 0,1 et non supérieur à 0,9, et un rapport (b₂'/b₂) entre la hauteur (b₂') et la longueur de côté (b₂) dans la direction longitudinale est non inférieur à 0,3 et non supérieur à 0,9, et
dans lequel dans un cas où le cristal photonique est un cristal photonique à réseau carré,
un rapport (b₁'/b₁) entre la longueur de base (b₁') et la longueur de côté (b₁) dans la direction latérale est non inférieur à 0,1 et non supérieur à 0,5, et un rapport (b₂'/b₂) entre la hauteur (b₂') et la longueur de côté (b₂) dans la direction longitudinale est non inférieur à 0,3 et non supérieur à 0,9.
